# EUROPEAN PATENT SPECIFICATION

(11) **EP 2 320 474 B1**
(45) Date of publication and mention of the grant of the patent: **10.09.2014**
(21) Application number: 09773583.1
(22) Date of filing: 03.07.2009
(51) Int. Cl.: H01L 31/04, H01L 27/142

(54) **SOLAR CELL AND METHOD FOR MANUFACTURING THE SAME**
SOLARZELLENHERSTELLUNGSVERFAHREN UND SOLARZELLE
PROCÉDÉ DE FABRICATION DE CELLULE SOLAIRE ET CELLULE SOLAIRE

(30) Priority: 04.07.2008 JP 2008176285; 08.10.2008 JP 2008261796
(43) Date of publication of application: 11.05.2011
(73) Proprietor: ULVAC, INC., Chigasaki-shi Kanagawa 253-8543 (JP)
(72) Inventor: WATAI, Miwa, Sammu-shi Chiba 289-1226 (JP); SAITO, Kazuya, Sammu-shi Chiba 289-1226 (JP); KOMATSU Takashi, Sammu-shi Chiba 289-1226 (JP); SAKIO Susumu, Sammu-shi Chiba 289-1226 (JP); WAKAI Masafumi, Sammu-shi Chiba 289-1226 (JP); KUROIWA Shunji, Sammu-shi Chiba 289-1226 (JP)
(74) Representative: Eisenführ Speiser
(86) International application number: PCT/JP2009/062225
(87) International publication number: WO 2010/002005

(56) References cited:
- WO-A2-2007/044555
- JP-A- 2000 058 886
- JP-A- 2001 274 447
- JP-A- 2001 274 447
- JP-A- 2005 101 384
- JP-A- 2006 222 416
- US-A1- 2007 193 619

## Description

### BACKGROUND OF THE INVENTION

### Field of the Invention

The present invention relates to a solar cell and a method for manufacturing a solar cell.

### Background Art

In recent years, in view of efficient use of energy, solar cells are more widely used than ever before.

Specifically, a solar cell in which a silicon single crystal is utilized has a high level of energy conversion efficiency per unit area.

However, in contrast, in the solar cell in which the silicon single crystal is utilized, a silicon single crystal ingot is sliced, a sliced silicon wafer is used in the solar cell; therefore, a large amount of energy is spent for manufacturing the ingot, and the manufacturing cost is high.

Specifically, at the moment, in a case of realizing a solar cell having a large area which is placed out of doors or the like, when the solar cell is manufactured by use of a silicon single crystal, the cost considerably increases.

Consequently, as a low-cost solar cell, an amorphous silicon solar cell that can be further inexpensively manufactured and that employs a thin film made of amorphous silicon is in widespread use.

An amorphous silicon solar cell has a photoelectric converter in which a transparent electrode such as a so-called TCO (transparent conductive oxide) is formed as a top electrode on, for example, a glass substrate, and a semiconductor film (photoelectric conversion layer) composed of amorphous silicon and an Ag thin film that becomes a back electrode are stacked in layers on the top electrode.

The semiconductor film is constituted of a layered structure that is referred to as a pin-junction in which an amorphous silicon film (i-type) is sandwiched between p-type and n-type silicon films, the amorphous silicon film (i-type) generating electrons and holes when receiving light.

The electrons and holes generated by sunlight actively transfer due to a difference in the electrical potentials between p-type and n-type semiconductors, and a difference in the electrical potentials between both faces of the electrodes is generated when the transfer thereof is continuously repeated.

However, in the above-described amorphous silicon solar cell, if the photoelectric converter having a large area is only uniformly formed on the substrate, and there is a problem in that the difference in the electrical potentials is small.

Consequently, the structure is well-known, in which compartment elements (solar cells) are formed so that the photoelectric converter is electrically separated into the compartment elements by a predetermined size, and adjacent compartment elements are electrically connected with each other.

Specifically, an integrated structure is known in which grooves are formed on the photoelectric converter having a large area uniformly formed on the substrate by use of a laser light or the like, a plurality of compartment elements formed in a longitudinal rectangular shape is formed, and the compartment elements are electrically connected to each other in series.

As a method for manufacturing the above-described solar cell, for example, a technique disclosed in Japanese Unexamined Patent Application, First Publication No. 2007-273858 is known.

In Japanese Unexamined Patent Application, First Publication No. 2007-273858, a transparent electrode is formed on a glass substrate in a first step, first grooves are formed on the transparent electrode by a laser-scribing.

Subsequently, a semiconductor film having a photoelectric conversion function provided on the transparent electrode, thereafter, a part of the semiconductor film is removed due to scribing by use of a laser light, grooves used for electrical connection are formed. Consequently, the semiconductor film that is a photoelectric conversion film is separated into longitudinal rectangular shapes.

Furthermore, after the back electrode is formed on the semiconductor film, common grooves are formed on both of the back electrode and the semiconductor film due to scribing by use of a laser light.

At this time, a material used for forming a back electrode that is formed on the semiconductor film is also implanted in the grooves used for electrical connection.

In the above-described manner, by performing the scribing in each step for forming each layer, each layer is separated, the back electrode is connected to the top electrode, and compartment elements are electrically connected to each other.

However, recently, a glass substrate on which a film is formed has tended to increase in size, there is a case where a substrate having a length of 1 m or more is used.

In this case, as conventional technique described above, when the scribing is performed in each step for forming each layer, there is a problem in that it is difficult to ensure the precision of the scribing.

That is, when a large-scale glass substrate is used, due to warpage or the like occurring in the glass substrate, which is caused by the weight of the glass substrate or the like, it is impossible to form grooves in which a desired alignment is obtained, there is a problem in that bent grooves are formed.

Because of this, there is a concern that, it is impossible to reliably separate adjacent compartment elements into each other or adjacent grooves are in contact with each other.

As a result, it is impossible to ensure insulation between adjacent compartment elements, adjacent compartment elements are short-circuited, and there is a problem in that the power generation efficiency of the compartment elements is degraded.

In contrast, it is believed that, as a countermeasure, due to increasing the distance between the grooves, adjacent grooves are prevented from being in contact with each other, insulation between adjacent compartment elements is ensured.

However, in this case, there is a problem in that an effective area of the compartment element decreases.

As a result, there is a problem in that the power generation efficiency of each compartment element is degraded.

In addition, due to performing the scribing in each step for forming each layer, there are cases where the length of time of laser processing necessarily increases in the length of time of manufacturing process, a rinsing step is necessary for removing particles generated at the periphery of the portions that are scribed when the scribing step is performed, or the like, there is a problem in that manufacturing efficiency is degraded.

On the other hand, it is known that the photoelectric conversion efficiency of an amorphous silicon solar cell is degraded, compared to a crystalline solar cell, in theoretical concept.

As a method for solving the problem, a technique for preventing degradation of the photoelectric conversion layer under manufacturing processes is of importance in addition to development of a photoelectric conversion layer having a high degree of photoelectric conversion efficiency.

It is believed that the degradation of the photoelectric conversion layer in the foregoing manufacturing process is mainly caused by a phenomenon described as follows.

As described above, when grooves are formed by use of a laser, it is generally known that the above-described transparent electrode composed of TCO sufficiently absorbs a laser beam having a wavelength of an infrared region such as an infrared laser, YAG (Yttrium Aluminium Garnet) having a wavelength of 1064 nm, and the transparent electrode is thereby heated, in addition, the above-described semiconductor film composed of amorphous silicon sufficiently absorbs a laser beam having a wavelength of a visible light region such as a green laser having a wavelength of 532 nm which is second-order harmonic of the infrared laser, and the semiconductor film is thereby heated.

Therefore, the above-described infrared laser is used in the case of cutting the above-described transparent electrode, and the green laser is well-employed in the case of cutting the above-described semiconductor film.

In the method for employing the infrared laser, the output thereof is greater than that of the green laser, and there is thereby a problem in that each of layers that are disposed at the periphery of the grooves is easily affected according to influences caused by heat generation due to laser irradiation.

In first of the influences caused by heat generation due to laser irradiation, for example, the heat generated by laser irradiation is transmitted to each of layers that are disposed at the periphery of the grooves, and hydrogen atoms capping a dangling-bond of an amorphous silicon layer (semiconductor layer) in the periphery of the grooves are removed.

In the case where hydrogen atoms are removed from a semiconductor layer of a power-generation effective region due to the heat generated by laser irradiation when grooves adjacent to the power-generation effective region are formed, localized level is generated due to dangling-bond generated at this portion, and there is a problem in that photoelectric conversion efficiency of a solar cell is degraded.

In addition, in second, there is a concern that the molten material of a top electrode may scatter inside the grooves when grooves is formed.

In this case, a back electrode formed so at to be lateral to the semiconductor layer opposite to the top electrode, and the top electrode, are bridged and connected to each other, due to the scattered material of the top electrode, and there is a concern that the both of electrodes are short-circuited.

JP 2001 274447 A discloses that in an integrated thin film solar battery, a back electrode layer, at least one crystalline semiconductor photoelectric conversion unit layer, and a transparent electrode layer, are formed on an insulating substrate and divided into a plurality of portions by a plurality of separating grooves so as to form a plurality of cells, and the cells are electrically connected in series through conductive connecting members. The method of manufacturing the solar battery includes a step of forming the groove, which separates the electrode layer into a plurality of transparent electrodes, into the electrode layer through at least the whole thickness of the layer, by irradiating the free surface of the layer with a scribing laser beam and, thereafter, completely separating a conductive semiconductor layer adjoining to the layer from the layer in the groove by dry etching.

### SUMMARY OF THE INVENTION

The invention was made in order to solve the above problems, and has a first object to provide a solar cell and a method for manufacturing the solar cell, which ensures insulation between adjacent compartments by scribing with a high degree of precision even if a large-scale substrate is used, and in which it is possible to improve the power generation efficiency of a compartment element.

In addition, a second object is to provide a solar cell and a method for manufacturing the solar cell, which shortens the length of required time for a laser scribing step, which suppresses the influences caused by heat generation at the time of scribing, and in which it is possible to improve the photoelectric conversion efficiency.

The invention is described in independent claims 1 and 6.

In order to solve the above-described problems,

a method for manufacturing a solar cell of a first aspect of the present invention includes a scribing step in which grooves electrically-separating a photoelectric converter into a plurality of compartment sections are formed after the photoelectric converter is formed on a substrate by stacking a first-electrode layer, a photoelectric conversion layer, and a second-electrode layer in this order.

In the scribing step, a first groove is formed which penetrates through the first-electrode layer, the photoelectric conversion layer, and the second-electrode layer, and which separates the first-electrode layer, the photoelectric conversion layer, and the second-electrode layer into a first compartment section and a second compartment section, a second groove is formed parallel to the first groove, the second groove penetrates through the photoelectric conversion layer and the second-electrode layer, and the second groove separates the photoelectric conversion layer and the second-electrode layer into the second compartment section and a third compartment section, a third groove is formed parallel to the first groove and is lateral to the second groove opposite to the first groove adjacent to the second groove, the third groove penetrates through the photoelectric conversion layer and the second-electrode layer, and the third groove separates the photoelectric conversion layer and the second-electrode layer into the third compartment section and a fourth compartment section, and a fourth groove is formed parallel to the first groove, lateral to the first groove opposite to the second groove, the fourth groove penetrates through the photoelectric conversion layer and the second-electrode layer, and the fourth groove separates at least the photoelectric conversion layer and the second-electrode layer into the fourth compartment section and the first compartment section between the first groove and the fourth compartment section that becomes a power-generation effective region.

The method includes: an insulating-layer forming step in which an insulating layer is formed inside the first groove and the fourth groove after the scribing step; and wiring-layer forming step in which a wiring layer electrically connecting the plurality of compartment sections to each other is formed.

In the wiring-layer forming step, the wiring layer passes from the first-electrode layer that is exposed at a bottom face of the second groove, through the inside of the second groove and a surface of the insulating layer, to a surface of the second-electrode layer that is disposed so as to be lateral to the fourth groove opposite to the second groove, and the wiring layer electrically connects the plurality of compartment sections to each other.

According to this method, since a solar cell is formed by scribing each groove after all of layers, each of which constitutes the solar cell, are formed, it is possible to shorten the length of required time for a laser scribing step, compared to conventional cases where the scribing is performed in every step for forming each layer.

Because of this, the tact time is shortened in a solar cell manufacturing process, and it is possible to improve productivity of an apparatus for manufacturing a solar cell.

Consequently, the fourth groove prevents heat transmission that is generated at the periphery of the first groove due to a high-output laser such as an infrared laser which is used when forming the first groove, and prevents the removal of hydrogen atoms, due to influence caused by the above-described heat along with the heat transmission, from being propagated to the power-generation effective region.

Because of this, it is possible to manufacture a solar cell having a photoelectric conversion layer with degradation less than before.

For this reason, since it is possible to increase the surface area of each compartment section that becomes a power-generation effective region, it is possible to improve the photoelectric conversion efficiency of each solar cell.

In addition, even if the first-electrode layer and a back electrode layer (i.e., second-electrode layer) are bridged and connected to each other due to a top-electrode layer (i.e., first-electrode layer) being melted and scattered when forming the first groove, since the first groove is separated from the compartment section that becomes a power-generation effective region by the fourth groove into which the insulating layer is implanted, it is possible to reliably suppress the first-electrode layer and the second-electrode layer from being short-circuited in the power-generation effective region.

That is, since it is possible to ensure the insulation between the compartment section having a power-generation effective region and a short-circuited portion in the groove adjacent thereto, it is possible to suppress degradation of the photoelectric conversion efficiency due to the short-circuiting.

In the method for manufacturing a solar cell of the first aspect of the present invention, it is preferable that an infrared laser be used as a first laser forming the first groove; a visible laser be used as a second laser forming the second groove, a third laser forming the third groove, and a fourth laser forming the fourth groove; and in the scribing step, each of the lasers are scanned so that a position irradiated with a first laser, a position irradiated with a second laser, a position irradiated with a third laser, and a position irradiated with a fourth laser are positioned parallel to each other with desired distances therebetween in the photoelectric converter, and thereby forming each of the grooves.

As the visible laser, for example, a second-order harmonic of the infrared laser may be used.

According to this method, by using the infrared laser for forming the first groove, it is possible to manufacture a solar cell in which the first-electrode layer is reliably separated, the fourth groove is formed by use of the second-order harmonic of the infrared laser.

Consequently, even if influences caused by heat such as a degradation of a photoelectric conversion layer or short-circuiting between a first-electrode layer and a second-electrode layer are generated at the periphery of the first groove, it is possible to separate the foregoing degraded portion or the like from the power-generation effective region by use of the method which is less affected by heat.

Therefore, it is possible to ensure insulation between the compartment section having a power-generation effective region and a short-circuited portion of the groove adjacent thereto, degradation of the photoelectric conversion efficiency which is caused by the short-circuiting is suppressed; since it is possible to increase the surface area of each compartment section that becomes a power-generation effective region, it is possible to improve the photoelectric conversion efficiency of each solar cell.

In the method for manufacturing a solar cell of the first aspect of the present invention, in the scribing step, it is preferable that, relative positions of the first laser, the second laser, the third laser, and the fourth laser be fixed, and each groove be formed and scanned with each laser.

In this case, since it is possible to separate the solar cell having the above-described photoelectric conversion layer, which is less affected by heat, by one-pass scanning with a laser, it is possible to shorten the length of required time for a laser scribing step, compared to conventional cases where the scribing is performed in every step for forming each layer.

Because of this, the tact time is shortened in a solar cell manufacturing process, and it is possible to improve productivity of an apparatus for manufacturing a solar cell.

In the method for manufacturing a solar cell of the first aspect of the present invention, in the scribing step, it is preferable that relative positions of the second laser, the third laser, and the fourth laser be fixed, and the first groove be formed and scanned with the first laser after the second groove, the third groove, and the fourth groove are formed and scanned with each laser at the same time.

In this case, since the compartment section that was preliminarily separated from an effective power generation region with a second harmonic of an infrared laser which is less affected by heat is thereafter scanned with an infrared laser, it is possible to reliably further prevent influences caused by heat due to an infrared laser from being propagated, and it is possible to improve the photoelectric conversion efficiency of each solar cell.

In the method for manufacturing a solar cell of the first aspect of the present invention, in the scribing step, it is preferable that relative positions of the first laser, the second laser, the third laser, and the fourth laser be fixed, and each groove be formed at the same time by scanning each laser simultaneously.

A solar cell of a second aspect of the present invention includes: a photoelectric converter in which a first-electrode layer, a photoelectric conversion layer, and a second-electrode layer are stacked in layers, in this order, the photoelectric converter being formed on a substrate; and grooves electrically separating the photoelectric converter into a plurality of compartment sections.

The grooves include: a first groove penetrating through the first-electrode layer, the photoelectric conversion layer, and the second-electrode layer, and separating the first-electrode layer, the photoelectric conversion layer, and the second-electrode layer into a first compartment section and a second compartment section; a second groove in which a wiring layer electrically connecting the plurality of compartment sections to each other is formed, the second groove being parallel to the first groove and the second groove penetrating through the photoelectric conversion layer and the second-electrode layer, and separating the photoelectric conversion layer and the second-electrode layer into the second compartment section and a third second compartment section; a third groove being parallel to the first groove and lateral to the second groove opposite to the first groove adjacent to the second groove, the third groove penetrating through the photoelectric conversion layer and the second-electrode layer, and separating the photoelectric conversion layer and the second-electrode layer into the third compartment section and a fourth compartment section; and a fourth groove being parallel to the first groove, lateral to the first groove adjacent to the second groove, and disposed at the opposite side of the second groove, the fourth groove penetrating through the photoelectric conversion layer and the second-electrode layer, and separating at least the photoelectric conversion layer and the second-electrode layer into the fourth compartment section and the first compartment section between the first groove and the fourth compartment section that becomes a power-generation effective region.

An insulating layer insulating at least the first-electrode layer from the photoelectric conversion layer between the compartment sections adjacent to each other is formed inside the first groove; and an insulating layer insulating at least the photoelectric conversion layer from the second-electrode layer between the compartment sections adjacent to each other is formed inside the fourth groove.

The wiring layer passes from the first-electrode layer that is exposed at a bottom face of the second groove, through the inside of the second groove and a surface of the insulating layer, to a surface of the second-electrode layer that is disposed so as to be lateral to the fourth groove opposite to the second groove, and the wiring layer electrically connects the plurality of compartment sections to each other.

Here, the insulating layer formed inside the first groove is a first insulating layer, and the insulating layer formed inside the fourth groove is a second insulating layer.

With this configuration, the photoelectric converter formed on the substrate is separated by each groove so as to have a predetermined size, and it is possible to form a plurality of compartment sections having a power-generation effective region.

Consequently, by forming the insulating layers in the first groove and the fourth groove, it is possible to reliably separate the compartment section having a power-generation effective region from a compartment section adjacent to the compartment section, and it is possible to reliably prevent the grooves from being in contact with each other between adjacent grooves.

Consequently, since the wiring layer passing through the surface of the insulating layer is formed, and since the wiring layer connects the first-electrode layer that is exposed at the bottom face of the second groove and that is electrically separated by the first groove, to the second-electrode layer of the power-generation effective region, the insulation between adjacent compartment sections is ensured, it is possible to connect adjacent compartment sections in series.

Because of this, it is possible to reliably suppress the generation of leakage current or the like which is caused by short-circuiting between adjacent compartment sections, and it is possible to suppress degradation of the photoelectric conversion efficiency.

In addition, it is possible to reduce the distance between the first groove and a groove adjacent to the first groove (for example, second groove) by forming the insulating layer in the first groove.

Here, since the first groove is separated from the compartment section that becomes a power-generation effective region by forming the fourth groove that is lateral to the first groove opposite to second groove, it is possible to prevent generated heat transmission caused by an infrared laser or the like which is used when forming the first groove and to prevent the removal of hydrogen atoms due to influences caused by the above-described heat along with the heat transmission from being propagated to the power-generation effective region.

Consequently, it is possible to manufacture a solar cell having a photoelectric conversion layer with degradation less than before.

For this reason, since it is possible to increase the surface area of each compartment section that becomes a power-generation effective region, it is possible to improve the photoelectric conversion efficiency of each solar cell.

In addition, even if the first-electrode layer and a back electrode layer (i.e., second-electrode layer) are bridged and connected to each other due to a top-electrode layer (i.e., first-electrode layer) being melted and scattered when forming the first groove, since the first groove is separated from the compartment section that becomes a power-generation effective region by the fourth groove into which the insulating layer is implanted, it is possible to reliably suppress the first-electrode layer and the second-electrode layer from being short-circuited in the power-generation effective region.

That is, since it is possible to ensure the insulation between the compartment section having a power-generation effective region and a short-circuited portion in the groove adjacent thereto, it is possible to suppress degradation of the photoelectric conversion efficiency due to the short-circuiting.

### BRIEF DESCRIPTION OF THE DRAWINGS

FIG. 1 is a plan view showing an amorphous silicon solar cell of a first embodiment of the present invention.
FIG. 2 is a cross-sectional view taken along the line A-A' of FIG. 1.
FIG. 3A is a cross-sectional view taken along the line A-A' of FIG. 1, and is a flow sheet of the amorphous silicon solar cell.
FIG. 3B is a cross-sectional view taken along the line A-A' of FIG. 1, and is a flow sheet of the amorphous silicon solar cell.
FIG. 3C is a cross-sectional view taken along the line A-A' of FIG. 1, and is a flow sheet of the amorphous silicon solar cell.
FIG. 4 is a cross-sectional view showing a tandem-type solar cell of a second embodiment of the present invention.
FIG. 5 is a cross-sectional view showing an amorphous silicon solar cell of a third embodiment of the present invention.
FIG. 6 is a cross-sectional view showing an amorphous silicon solar cell of a modified example of the third embodiment of the present invention.
FIG. 7 is a cross-sectional view showing an amorphous silicon solar cell of a fourth embodiment not part of the present invention.
FIG. 8 is a cross-sectional view taken along the line A-A' of FIG. 7.
FIG. 9A is a cross-sectional view taken along the line A-A' of FIG. 7, and is a flow sheet of the amorphous silicon solar cell.
FIG. 9B is a cross-sectional view taken along the line A-A' of FIG. 7, and is a flow sheet of the amorphous silicon solar cell.
FIG. 9C is a cross-sectional view taken along the line A-A' of FIG. 7, and is a flow sheet of the amorphous silicon solar cell.
FIG. 10 is a cross-sectional view showing an amorphous silicon solar cell of a fifth embodiment not part of the present invention.
FIG. 11 is a cross-sectional view showing an amorphous silicon solar cell of a sixth embodiment not part of the present invention.

### DESCRIPTION OF THE PREFERRED EMBODIMENTS

Next, a solar cell and method for manufacturing a solar cell relating to embodiments of the present invention will be described with reference to drawings.

In these drawings which are utilized in the following explanation, appropriate changes have been made in the scale of the various members, in order to represent them at scales at which they can be easily understood.

### First Embodiment

### Amorphous Silicon Solar Cell

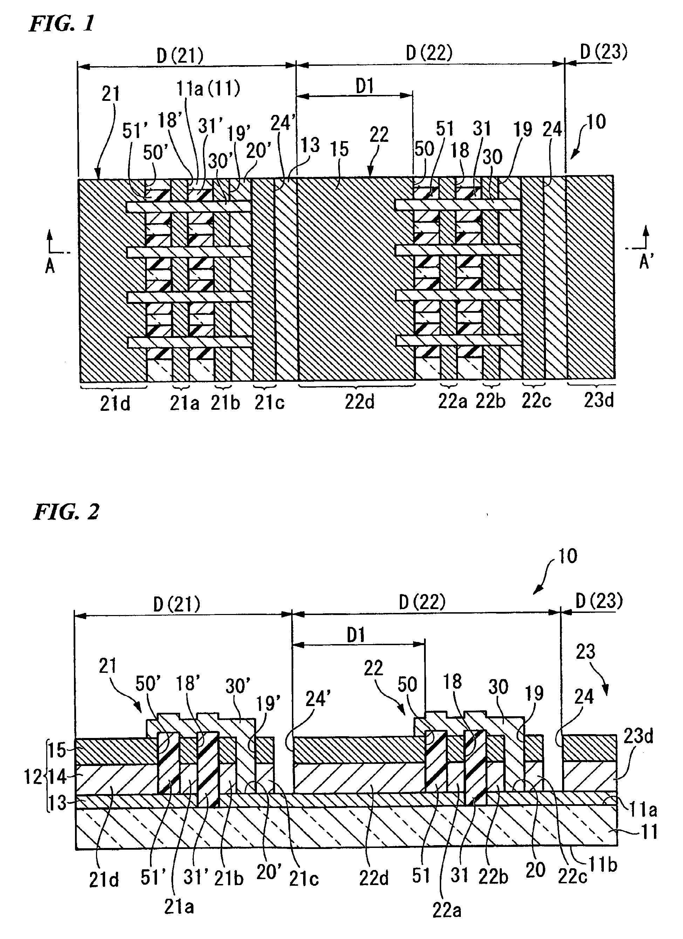

FIG. 1 is a plan view showing an amorphous silicon-type solar cell, and FIG. 2 is a cross-sectional view taken along the line A-A' of FIG. 1.

As shown in FIGS. 1 and 2, a solar cell 10 is a so-called single-type solar cell and has a structure in which a photoelectric converter 12 is formed on one face 11a (hereinafter, refer to back face 11a) of a transparent substrate 11 having an insulation property.

The substrate 11 is composed of an insulation material having an excellent sunlight transparency and durability such as a glass or a transparent resin, and a length of the substrate 11 is, for example, approximately 1 m.

In the solar cell 10, sunlight is incident to the side of the substrate 11 opposite to the photoelectric converter 12, that is, the other face of the substrate 11 (hereinafter, refer to top face 11b).

The photoelectric converter 12 has a structure in which a semiconductor layer (photoelectric conversion layer) 14 is held between a top electrode (first-electrode layer) 13 and a back electrode (second-electrode layer) 15, and is formed on the entire area of the back face 11a of the substrate 11 except for the periphery thereof.

The top electrode 13 is composed of a transparent electroconductive material, an oxide of metal having an optical transparency, for example, TCO such as ITO (Indium Tin Oxide), FTO (Fluorine-doped Tin Oxide), and is formed on the back face 11a of the substrate 11 along with a surface-texture.

A semiconductor layer 14 is formed on the top electrode 13.

The semiconductor layer 14 has, for example, a pin-junction structure in which an i-type amorphous silicon film (not shown in the figure) is sandwiched between a p-type amorphous silicon film (not shown in the figure) and an n-type amorphous silicon film (not shown in the figure).

In the pin-junction structure, when sunlight is incident to the semiconductor layer 14, electrons and holes are generated and actively transfer due to a difference in the electrical potentials between the p-type amorphous silicon film and the n-type amorphous silicon film; and a difference in the electrical potentials between the top electrode 13 and the back electrode 15 is generated when the transfer thereof is continuously repeated (photoelectric conversion).

The back electrode 15 is composed of a metal film having relatively high electroconductive rate and reflectance, for example, Ag, Al, Cu, or the like, and is stacked on the semiconductor layer 14.

In addition, in order to improve, for example, the barrier property between the back electrode 15 and the semiconductor layer 14 and reflectance, it is preferable that a transparent electrode such as TCO (not shown in the figure) be formed between the back electrode 15 and the semiconductor layer 14.

Here, the photoelectric converter 12 formed on the substrate 11 is partitioned by a predetermined size due to a lot of third grooves 24.

Namely, a region D that is surrounded between the third grooves 24 and third grooves 24' adjacent to the third grooves 24 is repeatedly formed; therefore a plurality of rectangular-shaped compartment elements (solar cell) 21, 22, and 23 are formed as seen from the substrate 11 in a vertical direction.

In addition, the above-described compartment elements 21, 22, and 23 are provided with first grooves 18, second grooves 19, and fourth grooves 50, which separate each of the compartment elements 21, 22, and 23 into a plurality of compartment sections (for example, compartment sections 22a to 22d of compartment element 22).

In addition, in the compartment element 22, a compartment section 22a corresponds to a third compartment section, a compartment section 22b corresponds to a fourth compartment section, a compartment section 22c corresponds to a second compartment section, and a compartment section 22d corresponds to a first compartment section.

In addition, in the compartment element 21, a compartment section 21a corresponds to a third compartment section, a compartment section 21b corresponds to a fourth compartment section, a compartment section 21c corresponds to a second compartment section, and a compartment section 21d corresponds to a first compartment section.

In addition, in the compartment element 23, a compartment section 23d corresponds to a first compartment section.

A first groove 18 separates the top electrode 13, the semiconductor layer 14, and the back electrode 15 of the photoelectric converter 12 from each other, between a first portion of the compartment element 22 (hereinafter, refer to compartment section 22a) and a second portion of the compartment element 22 adjacent to the compartment section 22a (hereinafter, refer to compartment section 22b).

Specifically, the first groove 18 is a groove that is cut in the thickness direction of the substrate 11 at each of end portions of the compartment sections 22a and 22b which are adjacent to each other so that the back face 11a of the substrate 11 is exposed thereto, and is formed so as to have a width of, for example, approximately 20 to 60 µm.

Similarly, each of a second groove 19, a third groove 24, and a fourth groove 50, which are described below is formed so as to have a width of, for example, approximately 20 to 60 µm.

In the compartment element 22, a second groove 19 is formed adjacently to the first groove 18.

The second groove 19 is disposed so that the compartment section 22b is sandwiched between the first groove 18 and the second groove 19.

The second grooves 19 are formed in the width direction of the first groove 18 with the distance therebetween, and are formed in substantially parallel to the longitudinal direction of the first groove 18.

The second groove 19 separates the semiconductor layer 14 from the back electrode 15 of the photoelectric converter 12, between the compartment section 22b and a third portion of the compartment element 22 (hereinafter, refer to compartment section 22c).

The second groove 19 penetrates through the back electrode 15 and the semiconductor layer 14 of the photoelectric converter 12 in the thickness direction of the substrate 11, and is formed so as to reach a portion at which the surface of the top electrode 13 is exposed.

The second groove 19 serves as a contact hole that electrically connects adjacent compartment elements 22 and 23 to each other.

The top electrode 13 that is exposed in the second groove 19 of the compartment element 22 functions as a contact portion 20.

Consequently, the back electrode 15 of the compartment section 22a is connected to the contact portion 20 of the top electrode 13 in the second groove 19 by a wiring layer 30 described below; therefore, the compartment elements 22 and 23 which are adjacent to each other are connected to each other in series.

In addition, the distance between the first groove 18 and the second groove 19 (width of compartment section 22b) is 10 to 500 µm, it is preferable that the distance be 10 to 200 µm, and it is further preferable that the distance be approximately 10 to 100 µm.

By determining the width of the compartment section 22b as described above, it is possible to ensure the structure in which each of the first groove 18 and the second groove 19 is independent.

In addition, when forming an insulating layer 31 (first insulating layer) and a wiring layer 30 which are described below, it is possible to reliably implant the insulating layer 31 into the first groove 18, and it is possible to reliably implant the wiring layer 30 into the second groove 19.

Furthermore, in the compartment element 22, the above-described third groove 24 is formed at the side of the second groove 19 which is opposite to the first groove 18, that is, so as to be adjacent to the second groove 19.

The third grooves 24 are formed in the width direction of the second groove 19 with the distance therebetween, and are formed substantially parallel to the longitudinal direction of the first groove 18.

Similar to the second groove 19, the third groove 24 penetrates the back electrode 15 and the semiconductor layer 14 of the photoelectric converter 12 in the thickness direction of the substrate 11 and is formed so as to reach a portion at which the surface of the top electrode 13 is exposed.

For this reason, it is possible to separate the back electrode 15 and the semiconductor layer 14 of the photoelectric converter 12 from the back electrode 15 and the semiconductor layer 14 of the compartment element 23.

In addition, the distance between the second groove 19 of the compartment element 22 and the third groove 24 (width of compartment section 22c) depends on a degree of alignment precision in a laser-processing apparatus, and is preferably approximately 1 to 60 µm.

Due to setting the width of compartment section 22c in the above-described manner, it is possible to prevent the second groove 19 from being in contact with the third groove 24, since the compartment section 22c separating a plurality of compartment elements is reliably formed, it is possible to reliably separate the wiring layer 30 implanted into the second groove 19 from the compartment section 23d that becomes a power-generation effective region of near compartment element (for example, compartment element 23).

In addition, the fourth groove 50 parallel to the first groove 18 is formed so as to be lateral to the first groove 18 opposite to the second groove 19 in the compartment element 22.

The fourth groove 50 separates the back electrode 15 and the semiconductor layer 14 which are disposed between the first groove 18 of the compartment element 22 and the third groove 24' of the compartment element 21 adjacent to the compartment element 22, into two compartment sections.

Specifically, two compartment sections between the first groove 18 and the third groove 24' are constituted of the compartment section 22d formed between the fourth groove 50 and the third groove 24', and the above-described compartment section 22a formed between the fourth groove 50 and the first groove 18.

Consequently, a region D1 (compartment section 22d) surrounded between the third groove 24' of the compartment element 21 adjacent to the compartment element 22, and the fourth groove 50 of the compartment element 22 constitutes a power-generation effective region of the compartment element 22.

In addition, the width of the compartment section 22a is 10 to 500 µm, it is preferable that the width be 10 to 200 µm, and it is more preferable that the width be approximately 10 to 100 µm.

Due to setting the width of compartment section 22a in the above-described manner, it is possible to suppress heat damage from affecting the semiconductor layer 14 of the compartment section 22d that becomes a power-generation effective region D1 when forming the first groove 18 described below.

In the above-described manner, the above-described first groove 18, the second groove 19, the third groove 24, and the fourth groove 50 are formed in parallel to each other, the compartment element 22 is separated into the compartment sections 22a to 22d by the first groove 18, the second groove 19, the third groove 24, and the fourth groove 50.

Consequently, the first groove 18 penetrates the photoelectric converter 12 so as to reach a position that is exposed at the back face 11a of the substrate 11.

On the other hand, the second groove 19, the third groove 24, and the fourth groove 50 penetrate the back electrode 15 and the semiconductor layer 14 so as to reach a position that is exposed at the top electrode 13.

That is, the top electrode 13 is formed on the entire area between the first grooves 18 and 18' of the compartment elements 22 and 21 which are adjacent to each other. On the other hand, the semiconductor layer 14 and the back electrode 15 are separated by each of the first groove 18, the second groove 19, the third groove 24, and the fourth groove 50 in each compartment element 22.

Here, the insulating layer 31 is implanted into the above-described first groove 18.

As shown in FIG. 1, the insulating layers 31 are formed in the first grooves 18 in the longitudinal direction of the first groove 18 with the distance therebetween.

In addition, as shown in FIG. 2, the insulating layer 31 is formed so that the top of the insulating layer 31 protrudes from the surface of the back electrode 15 of the photoelectric converter 12 in the thickness direction of the insulating layer 31.

In addition, as a material used for the insulating layer 31, an ultraviolet-curable resin, a heat-curable resin, or the like having an insulation property can be used, for example, an acrylic-ultraviolet-curable resin (for example, ThreeBond 3042) is preferably used.

In addition, SOG (Spin on Glass) or the like can also be used in addition to the foregoing resin material.

Moreover, an insulating layer 51 (second insulating layer) composed of the constituent material which is similar to the above-described insulating layer 31 is also implanted into the fourth groove 50.

As shown in FIG. 1, the insulating layers 51 are formed with the distance that is similar to that of the insulating layers 31 formed in the first grooves 18, and are formed along the longitudinal direction of the fourth groove 50.

Additionally, as shown in FIG. 2, the insulating layer 51 is formed so that the top of the insulating layer 51 protrudes from the surface of the back electrode 15 of the photoelectric converter 12 in the thickness direction of the insulating layer 51.

The wiring layer 30 that is disposed on the surface of the back electrode 15 of the compartment section 22d, led to the inside of the second groove 19, and covers the surface of the insulating layers 31 and 51, is formed on the surface of the back electrode 15.

The wiring layer 30 is formed so as to correspond to each position of the insulating layers 31 and 51, and formed along the longitudinal direction of the first groove 18 with the distance therebetween in similar to the insulating layers 31 and 51.

The wiring layer 30 is a layer electrically connecting the back electrode 15 of the compartment section 22d of the compartment element 22 to the top electrode 13 of the compartment section 23d of the compartment element 23, and is formed so as to bridge between the back electrode 15 of the compartment section 22d and the top electrode 13 that is exposed in the second groove 19.

That is, one end of the wiring layer 30 (first end) is connected to the surface of the back electrode 15 of the compartment section 22d, and the other end of the wiring layer 30 (second end) is connected to the contact portion 20 of the top electrode 13 which is exposed in the second groove 19.

With this configuration, the compartment section 22d of the compartment element 22 is connected to the compartment section 23d of the compartment element 23 in series.

The compartment section 23d of the compartment element 23 is formed so as to be lateral to the third groove 24 opposite to the compartment element 22.

Similarly, since the wiring layer 30' is formed, the compartment section 21d of the compartment element 21 is connected to the compartment section 22d of the compartment element 22 in series.

In addition, as the formation material of the wiring layers 30 and 30', a material having an electroconductivity, for example, low-temperature firing type nano-ink metal (Ag) or the like is used.

In addition, the compartment elements 21 and 23 have the structure D which is identical to the compartment element 22 as described above. However, in the case where it is necessary to distinguish between the compartment element 22 adjacent to the compartment elements 21 and 23, and the compartment elements 21 and 23, for convenience, a compartment element that is adjacent to the fourth groove 50 as seen from the compartment section 22b is shown as the compartment element 21, and a compartment element that is adjacent to the third groove 24 as seen from the compartment section 22b is shown as the compartment element 23 in the drawings.

In addition, the constituent elements of the compartment element 21 corresponding to the first groove 18, the second groove 19, the contact portion 20, the third groove 24, the wiring layer 30, the insulating layer 31, and the fourth groove 50 which are the constituent elements of the compartment element 22, are shown as a first groove 18', a second groove 19', a contact portion 20', a third groove 24', a wiring layer 30', an insulating layer 31', and a fourth groove 50', respectively.

### Method For Manufacturing Amorphous Silicon Solar Cell

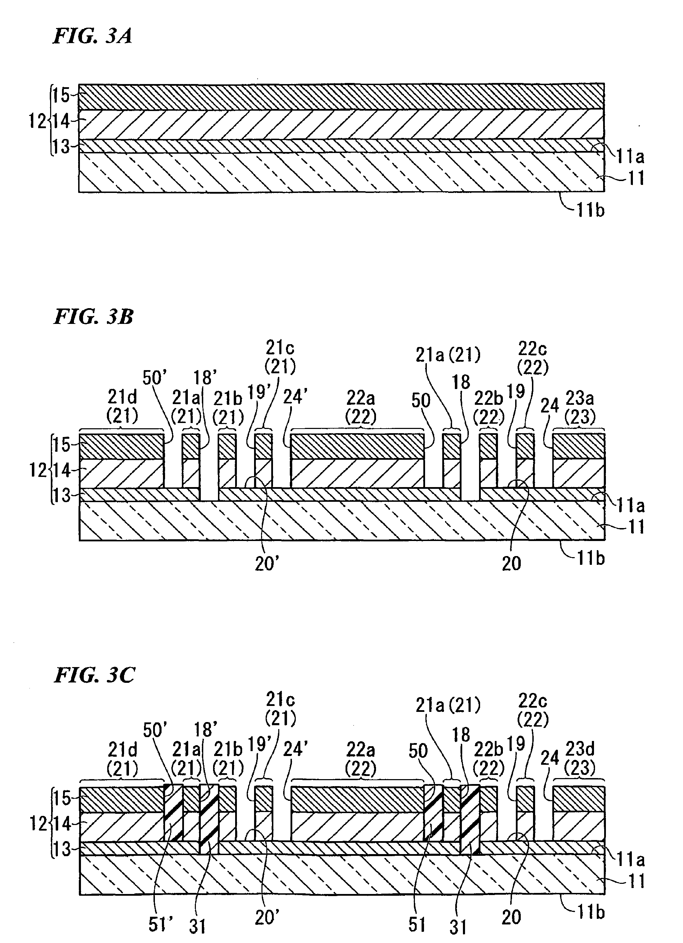

Next, with reference to FIGS. 1 to 3C, a method for manufacturing the above-described amorphous silicon solar cell will be described.

FIGS. 3A to 3C are cross-sectional views taken along the line A-A' of FIG. 1, and are flow sheets of the amorphous silicon solar cell.

Firstly, as shown in FIG. 3A, a photoelectric converter 12 is formed on the entire area of the back face 11a of the substrate 11 except for the periphery thereof (photoelectric converter forming step).

Specifically, a top electrode 13, a semiconductor layer 14, and a back electrode 15 are stacked in layers, in this order, on the back face 11a of the substrate 11 by a CVD method, a sputtering method, or the like.

Subsequently, as shown in FIG. 3B, the photoelectric converter 12 formed on the substrate 11 is partitioned by a predetermined size, and a compartment element 22 (compartment sections 22a to 22d) is thereby formed (scribing step).

Additionally, a compartment element 21 (compartment sections 21a to 21d) and a compartment element 23 (for example, compartment section 23d, or the like) can be formed by a similar method of forming the compartment element 22.

Here, in the first embodiment, a first groove 18, a second groove 19, a third groove 24, and a fourth groove 50 are simultaneously formed by use of a laser-processing apparatus (not shown in the figure) irradiating the substrate 11 with lasers having two or more wavelengths (not shown in the figure).

Four laser light sources irradiating with lasers in order to form four grooves are arranged in the laser-processing apparatus.

Specifically, the relative positions which include the position irradiated with a first laser (not shown in the figure) forming the first groove 18, the position irradiated with a second laser (not shown in the figure) forming the second groove 19, the position irradiated with a third laser (not shown in the figure) forming the third groove 24, and the position irradiated with a fourth laser (not shown in the figure) forming the fourth groove 50, are fixed.

As a laser of the first embodiment, a pulsed YAG (Yittrium Aluminium Garnet) laser or the like can be used.

It is preferable that, for example, an infrared laser (IR: infrared laser) having a wavelength of 1064 nm be used as the first laser forming the first groove 18.

In addition, it is preferable that a SHG (second harmonic generation) laser having a wavelength of 532 nm be used as the second to the fourth lasers forming the second groove 19, the third groove 24, and the fourth groove 50.

That is, it is preferable that a visible laser such as a green laser which is second-order harmonic of the first laser be used as the second to the fourth lasers.

In the laser-processing apparatus, the substrate 11 is simultaneously scanned along a surface thereof with the first to the fourth lasers onto a top face 11b of the substrate 11 toward the photoelectric converter 12.

Because of this, in the region that is irradiated with the laser having a wavelength of 1064 nm, the first laser heats up the top electrode 13 and the top electrode 13 evaporates.

Consequently, the semiconductor layer 14 and the back electrode 15 which are stacked in layers on the top electrode 13 of the region that is irradiated with the first laser are removed by an expansive force top generated in the electrode 13.

For this reason, in the region that is irradiated with the first laser having a wavelength of 1064 nm, the first groove 18, to which the back face 11a of the substrate 11 is exposed, is formed.

In contrast, in the region that is irradiated with the laser having a wavelength of 532 nm (the second to the fourth lasers), the laser heats up the semiconductor layer 14 and the semiconductor layer 14 evaporates.

Consequently, the back electrode 15 which is stacked in layers on the semiconductor layer 14 of the region that is irradiated with the laser is removed by an expansive force of the semiconductor layer 14.

For this reason, in the region that is irradiated with the laser having a wavelength of 532 nm, the second groove 19, the third groove 24, and the fourth groove 50, to which the surface of the top electrode 13 is exposed, are formed.

As a result, the first groove 18, the second groove 19, the third groove 24, and the fourth groove 50 are formed in parallel to each other, a compartment element 22 which is separated by a predetermined size and which has a power-generation effective region D1 (compartment section 22d) is formed between, for example, adjacent third grooves 24 and 24'.

At this time, the top electrode 13 is formed on the entire area between the first grooves 18 and 18' which are adjacent to each other.

On the other hand, the semiconductor layer 14 and the back electrode 15 are separated by each of the first grooves 18 and 18', the second grooves 19 and 19', and the third grooves 24 and 24' of each of the compartment elements 21, 22, and 23.

Next, as shown in FIG. 3C, an insulating layer 31 is formed in the first groove 18 using an inkjet method, a screen printing method, a dispensing method, or the like, and an insulating layer 51 is formed in the fourth groove 50 (insulating-layer forming step).

In the case of forming the insulating layer 31 using an inkjet method, an inkjet head ejecting the formation material of the insulating layer 31 and the substrate 11 (body to be processed) on which the photoelectric converter 12 is formed are relatively transferred, and the formation material of the insulating layer 31 is dropped on the substrate 11 from the inkjet head.

Specifically, inkjet heads (nozzles of inkjet head) are arrayed in a direction orthogonal to the longitudinal direction of the first groove 18, that is, corresponding to the distance between the first grooves 18; and the formation material of the insulating layer 31 is applied on the substrate 11 while scanning with the inkjet heads along the longitudinal direction of the first groove 18.

Also, a plurality of inkjet heads may be arrayed along the longitudinal direction of the first groove 18, and the formation material of the insulating layer 31 may be applied to each of the first grooves 18 of a plurality of compartment elements 21, 22, and 23 at the same time.

In addition, the insulating layer 51 can also be formed in a way similar to the case of forming the above-described insulating layer 31.

Consequently, after the formation material of the insulating layers 31 and 51 are applied to the inside of the first groove 18 and the fourth groove 50, the material of the insulating layers 31 and 51 is cured.

Specifically, in the case where an ultraviolet-curable resin is used as the material of the insulating layers 31 and 51, the formation material of the insulating layers 31 and 51 are cured by irradiating the formation material of the insulating layer with ultraviolet light.

On the other hand, in the case where a heat-curable resin or SOG is used as the formation material of the insulating layers 31 and 51, the formation material of the insulating layers 31 and 51 is cured by baking the formation material of the insulating layer.

Because of this, the insulating layers 31 and 51 are formed in the first groove 18 and the fourth groove 50.

As described above, it is possible to insulate between the compartment sections 22d and 22a, and between the compartment sections 22a and 22b, by forming the insulating layers 31 and 51 in the first groove 18 and the fourth groove 50 in the insulating-layer forming step.

Consequently, between the compartment sections 22d and 22a and between the compartment sections 22a and 22b, adjacent top electrodes 13 are not in contact with each other, and adjacent semiconductor layers 14 are not in contact with each other.

For this reason, between the compartment sections 22d and 22a and in the compartment sections 22a and 22b, it is possible to reliably suppress the generation of leakage current or the like which is caused by short-circuiting between the top electrodes 13 or short-circuiting between the semiconductor layers 14.

Subsequently, a wiring layer 30 is formed.

Specifically, the formation material of the wiring layer 30 is applied using an inkjet method, a screen printing method, a dispensing method, soldering, or the like, therefore, the wiring layer 30 reaches the surface of the back electrode 15 of the compartment section 22d, from the contact portion 20 of the top electrode 13 that is exposed in the second groove 19, through a surface of the insulating layers 31 and 51.

Consequently, after applying the formation material of the wiring layer 30, the formation material of the wiring layer 30 is baked and the wiring layer 30 is cured.

In addition, in the case where a heat-curable resin or SOG is used as the above-described formation material of the insulating layers 31 and 51, it is possible to perform curing the insulating layers 31 and 51 and curing the wiring layer 30 at the same time, and it is possible to improve the manufacturing efficiency.

In the above-described manner, the wiring layer 30 is formed on the insulating layers 31 and 51, the back electrode 15 of the compartment section 22d is connected to the top electrode 13 of the contact portion 20 by the wiring layer 30, therefore, it is possible to connect the compartment elements 22 and 23 which are adjacent to each other in series in addition to ensuring insulation between the compartment sections 22d and 22a and between the compartment sections 22a and 22b.

Because of this, it is possible to prevent the compartment elements 22 and 23 from being short-circuited to each other, it is possible to improve the photoelectric conversion efficiency.

As described above, as shown in FIGS. 1 and 2, the amorphous silicon-type solar cell 10 of the first embodiment is completed.

In the above-described first embodiment, a method for simultaneously forming the first groove 18, the second groove 19, the third groove 24, and the fourth groove 50 is used in the scribing step.

According to this method, in the scribing step in which the compartment elements 21 to 23 are formed after the photoelectric converter 12 is formed on the substrate 11, due to simultaneously forming each of the grooves 18, 19, 24, and 50, it is possible to separate the compartment section having the semiconductor layer 14 which is less affected by heat, by one-pass scanning with a laser.

For this reason, it is possible to shorten the length of required time for a laser scribing step, compared to conventional cases where the scribing is performed in every step for forming each layer.

Because of this, the tact time is shortened in a process of manufacturing solar cell 10, and it is possible to improve productivity of an apparatus for manufacturing a solar cell.

In addition, by simultaneously forming each of the grooves 18, 19, 24, and 50 from the top face 11b of the substrate 11 in the photoelectric converter 12, it is possible to form each of the grooves 18, 19, 24, and 50 with a high degree of precision.

That is, due to simultaneously forming each of the grooves 18, 19, 24, and 50 by simultaneously scanning with each laser, it is possible to perform the scribing while maintaining the relative positions of the grooves 18, 19, 24, and 50 in the scribing step.

Consequently, since the relative positions of the grooves 18, 19, 24, and 50 are not misaligned, adjacent grooves (for example, between the first groove 18 and the second groove 19) are prevented from being in contact with each other, and it is possible to form each groove with a high degree of precision.

Consequently, since it is possible to perform the scribing with a high degree of precision even on a large-scale substrate 11, it is possible to reliably separate the compartment sections 22a, 22b, 22c, and 22d from each other, and it is possible to reliably prevent adjacent grooves from being in contact with each other.

Because of this, since it is possible to ensure insulation between the compartment section 22d having the power-generation effective region D1, and the compartment 21a adjacent to the compartment section 22d, it is possible to suppress degradation of the photoelectric conversion efficiency due to short-circuiting between the compartment sections 22d and 22a.

Consequently, by forming each of the grooves 18, 19, 24, and 50 with a high degree of precision, it is possible to more reduce the distance between adjacent grooves 18, 19, 24, and 50 (between compartment sections) than before.

For this reason, since it is possible to increase an area of the power-generation effective region D1 (for example, compartment section 22d) of each of the compartment elements 21, 22, and 23, it is possible to improve the photoelectric conversion efficiency of each compartment element D.

Particularly, in the first embodiment, the fourth groove 50 penetrating through the semiconductor layer 14 and the back electrode 15 is formed lateral to the first groove 18 opposite to the second groove 19.

With this configuration, by forming the fourth groove 50 lateral to the first groove 18 opposite to the second groove 19, the first groove 18 is separated from the compartment section 22d that becomes a power-generation effective region D1.

Consequently, the fourth groove 50 prevents heat transmission that is generated at the periphery of the first groove 18 due to a high-output laser such as an infrared laser which is used when forming the first groove 18, and prevents the removal of hydrogen atoms, due to influence caused by the above-described heat along with the heat transmission, from being propagated to the power-generation effective region D1.

Because of this, it is possible to manufacture the solar cell 10 having the semiconductor layer 14 with degradation less than before.

For this reason, since it is possible to increase the surface area of each compartment section (for example, 22d) that becomes a power-generation effective region D1, it is possible to improve the photoelectric conversion efficiency of each of compartment elements 21 to 23.

In addition, even if the top electrode 13 and the back electrode 15 are bridged and connected to each other due to the top electrode 13 being melted and scattered when forming the first groove 18, the first groove 18 is separated from the compartment section 22d that becomes a power-generation effective region D1 by the fourth groove 50 into which the insulating layer 51 is implanted.

As a result, it is possible to reliably suppress the top electrode 13 and the back electrode 15 from being short-circuited in the power-generation effective region D1.

That is, since it is possible to ensure the insulation between the compartment section 22d having the power-generation effective region D1 and a short-circuited portion in the groove 18, it is possible to suppress degradation of the photoelectric conversion efficiency due to the short-circuiting.

### Second Embodiment

Next, the second embodiment of the present invention will be described.

In addition, in the explanation described below, identical symbols are used for the elements which are identical to those of the first embodiment, and the explanations thereof are omitted or simplified.

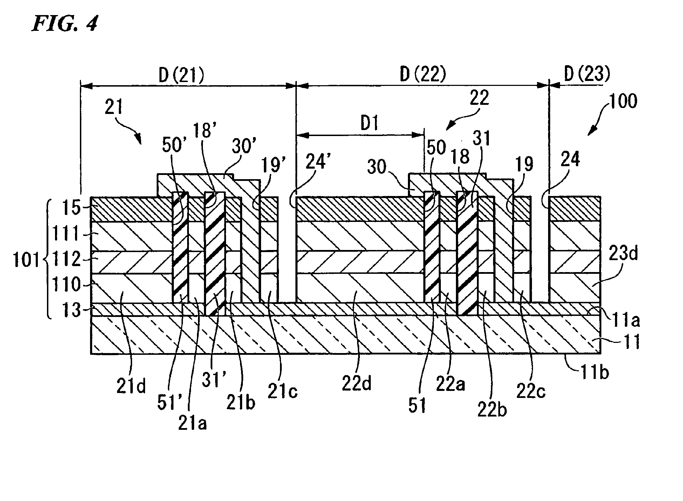

FIG. 4 is a cross-sectional view showing a tandem-type solar cell.

The second embodiment is different from the above-described first embodiment, in the sense of a so-called tandem-type solar cell being employed in which a first semiconductor layer composed of an amorphous silicon film and a second semiconductor layer composed of a microcrystalline silicon film are held between a pair of electrodes.

As shown in FIG. 4, a solar cell 100 has a structure in which a photoelectric converter 101 is formed on the back face 11a of the substrate 11.

The photoelectric converter 101 is configured so that the top electrode 13 formed on the back face 11a of the substrate 11, a first semiconductor layer 110 composed of amorphous silicon, an intermediate electrode 112 composed of TCO or the like, a second semiconductor layer 111 composed of microcrystalline silicon, and the back electrode 15 composed of a metal film are sequentially stacked in layers.

The first semiconductor layer 110 forms a pin-junction structure in which an i-type amorphous silicon film (not shown in the figure) is sandwiched between a p-type amorphous silicon film (not shown in the figure) similar to the above-described semiconductor layer 14 (with reference to FIG. 2) and an n-type amorphous silicon film (not shown in the figure).

In addition, the second semiconductor layer 111 forms a pin-junction structure in which an i-type microcrystalline silicon film (not shown in the figure) is sandwiched between a p-type microcrystalline silicon film (not shown in the figure) and an n-type microcrystalline silicon film (not shown in the figure).

Here, the first groove 18 penetrating through the top electrode 13 of the photoelectric converter 101, the first semiconductor layer 110, the intermediate electrode 112, the second semiconductor layer 111, and the back electrode 15 is formed in the photoelectric converter 101.

Similar to the above-described first embodiment, the first groove 18 is formed so as to expose the back face 11a of the substrate 11.

In addition, the second groove 19 is formed adjacent to the first groove 18.

The second groove 19 is formed so as to penetrate through the first semiconductor layer 110 of the photoelectric converter 101, the intermediate electrode 112, the second semiconductor layer 111 in the thickness direction of the substrate 11, and the back electrode 15, and so as to reach the position at which the surface of the top electrode 13 is exposed, in a manner similar to the above-described first embodiment.

Furthermore, the third groove 24 is formed lateral to the second groove 19 opposite to the first groove 18.

The third groove 24 is formed so as to penetrate through the first semiconductor layer 110 of the photoelectric converter 101, the intermediate electrode 112, the second semiconductor layer 111, and the back electrode 15 in the thickness direction of the substrate 11 and so as to reach the position at which the surface of the top electrode 13 is exposed, in a manner similar to the above-described first embodiment.

Consequently, a region D that is surrounded between the third grooves 24 and 24' is repeatedly formed; therefore a plurality of rectangular-shaped compartment elements 21, 22, and 23 are formed as seen from the substrate 11 in a vertical direction.

In addition, the fourth groove 50 is formed lateral to the first groove 18 opposite to the second groove 19.

The fourth groove 50 is formed so as to penetrate through the first semiconductor layer 110 of the photoelectric converter 101, the intermediate electrode 112, the second semiconductor layer 111, and the back electrode 15 in the thickness direction of the substrate 11 and so as to reach the position at which the surface of the top electrode 13 is exposed, in a manner similar to the above-described first embodiment.

Consequently, a region D1 (compartment section 22d) surrounded between the fourth groove 50 of the compartment element 22 and the third groove 24' of the compartment element 21 adjacent to the compartment element 22 constitutes a power-generation effective region D1 of the compartment element 22.

Here, the insulating layers 31 and 51 are implanted into the first groove 18 and the fourth groove 50, respectively.

The insulating layers 31 and 51 are formed in the first groove 18 and the fourth groove 50 in the longitudinal direction of the first groove 18 and the fourth groove 50 with the distance therebetween.

In addition, the tops of the insulating layers 31 and 51 are formed so as to protrude from the surface of the back electrode 15 of the photoelectric converter 101 in the thickness direction of the insulating layers 31 and 51.

In addition, the wiring layer 30 that is disposed on the surface of the back electrode 15 of the compartment section 22d, led to the contact portion 20 in the second groove 19, and covers the surface of the insulating layers 31 and 51, is formed on the surface of the back electrode 15.

The wiring layers 30 are formed so as to correspond to the positions of the insulating layers 31 and 51, formed along the longitudinal direction of the first groove 18 with the distance therebetween, and are similar to the insulating layers 31 and 51.

As described above, the solar cell 100 of the second embodiment is a tandem-type solar cell in which a-Si and microcrystalline Si are stacked in layers.

According to the second embodiment, it is possible to obtain the same actions and effects as the above-described first embodiment.

Furthermore, since the solar cell 100 having the tandem structure absorbs short-wavelength light of sunlight by the first semiconductor layer 110, and long-wavelength light by the second semiconductor layer 111, it is possible to improve the photoelectric conversion efficiency.

In addition, due to providing the intermediate electrode 112 between the first semiconductor layer 110 and the second semiconductor layer 111, since part of light passing through the first semiconductor layer 110 and reaching the second semiconductor layer 111 is reflected at the intermediate electrode 112 and is incident to the first semiconductor layer 110 again, the sensitivity of the photoelectric converter 101 is improved while contributing improvement of the photoelectric conversion efficiency.

In addition, in the above-described second embodiment, the case where the intermediate electrode 112 is employed is described, a structure in which an intermediate electrode 112 is not provided can be also adopted.

### Third Embodiment

Next, the third embodiment of the present invention will be described.

In addition, in the explanation described below, identical symbols are used for the elements which are identical to those of the first embodiment, and the explanations thereof are omitted or simplified.

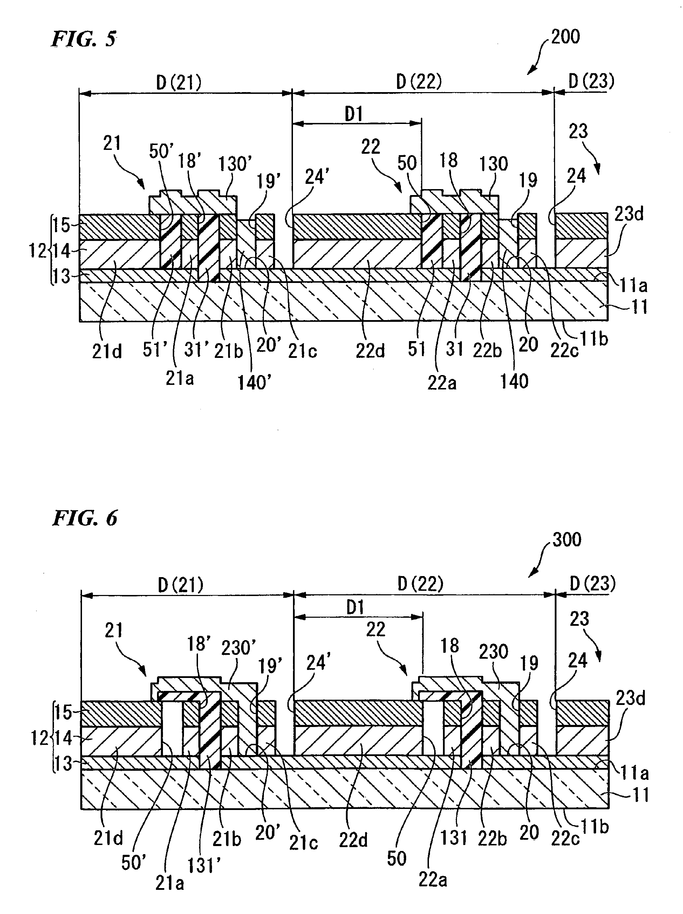

FIG. 5 is a cross-sectional view showing a single-type solar cell.

As shown in FIG. 5, the solar cell 200 of the third embodiment is provided with a first wiring layer 130 connecting the back electrode 15 of the compartment section 22d to the back electrode 15 of the compartment section 22b, and a second wiring layer 140 connecting the contact portion 20 to the back electrode 15 of the compartment section 22b.

The first wiring layer 130 passes through the surfaces of the insulating layers 31 and 51 and the compartment section 22a from the surface of the back electrode 15 of the compartment section 22d, reaches the surface of the back electrode 15 of the compartment section 22b, and is formed so as to bridge between the compartment sections 22d and 22b.

That is, one end of the first wiring layer 130 (first end) is connected to the surface of the back electrode 15 of the compartment section 22d.

On the other hand, the other end of the first wiring layer 130 (second end) is connected to the surface of the back electrode 15 of the compartment section 22b.

The first wiring layer 130 is formed so as to correspond to each position of the insulating layers 31 and 51.

For example, in the case where the insulating layers 31 and 51 are formed on the entire area of the first groove 18 in the longitudinal direction thereof, the first wiring layer 130 may be formed on the entire area of the insulating layers 31 and 51 or on the insulating layer 31 with the distance therebetween in the longitudinal direction thereof.

In addition, in the case where the insulating layers 31 and 51 are formed along the longitudinal direction of the first groove 18 with the distance therebetween, the first wiring layer 130 may be formed along the longitudinal direction of the first groove 18 with the distance therebetween in similar to the insulating layers 31 and 51.

The second wiring layer 140 is formed so as to be implanted into the second groove 19, and reaches the position which is in contact with the back electrode 15 from the contact portion 20 (bottom face) which is exposed in the second groove 19.

Consequently, top electrode 13 which is exposed at the contact portion 20 is connected to the back electrode 15 of the compartment section 22b.

Moreover, the second wiring layer 140 may protrude from the surface of the back electrode 15, or it is not necessary to protrude therefrom, as long as the second wiring layer 140 is formed so as to reach the side which is closer to the back electrode 15 than the boundary portion between the semiconductor layer 14 and the back electrode 15, that is, the position at which the back electrode 15 is disposed in the thickness direction of the solar cell 200.

The second wiring layer 140 is formed along the longitudinal direction of the second groove 19 with the distance therebetween.

Additionally, it is not necessary for the distance between the second wiring layers 140 to coincide with each distance between the first wiring layers 130 along the longitudinal direction of the first groove 18.

In addition, the second wiring layer 140 may be formed at the entire area along the longitudinal direction of the second groove 19.

Because of this, the first wiring layer 130 and the second wiring layer 140 are mutually connected to the back electrode 15 of the compartment section 22b, and the first wiring layer 130 is electrically connected to the second wiring layer 140 with the back electrode 15 of the compartment section 22b interposed therebetween.

Consequently, the compartment section 22d of the compartment element 22 is connected to the compartment section 23d of the compartment element 23 in series.

The compartment section 23d of the compartment element 23 is formed so as to be lateral to the third groove 24 opposite to the compartment element 22.

Similarly, due to the first wiring layer 130' and the second wiring layer 140' of the compartment element 21, the compartment section 21d of the compartment element 21 is connected to the compartment section 22d of the compartment element 22 in series.

Therefore, according to the third embodiment, since the first wiring layer 130 and the second wiring layer 140 are mutually connected to the back electrode 15 of the compartment section 22b, it is possible to electrically connect the first wiring layer 130 to the second wiring layer 140 by the back electrode 15, in addition to obtaining the same actions and effects as the above-described first embodiment.

For this reason, unlike the first embodiment, since it is not necessary to continuously form the wiring layer 30 (refer to FIG. 2) from the back electrode 15 of the compartment section 22d to the contact portion 20, it is possible to reduce cost of material of a wiring layer.

In addition, since it is not necessary for the distance between the first wiring layer 130 and the second wiring layer 140 to coincide with, for example, the longitudinal direction of the first groove 18, it is possible to improve the manufacturing efficiency.

### Modified Example

Next, the modified example of the present invention will be described.

In addition, in the explanation described below, identical symbols are used for the elements which are identical to those of the third embodiment, and the explanations thereof are omitted or simplified.

FIG. 6 is a cross-sectional view showing a single-type solar cell.

As shown in FIG. 6, in the solar cell 300 of the modified example, the insulating layer 131 (131') formed in the first groove 18 covers the surface of the compartment section 22a, and is bridged to the surface of the compartment section 22d.

Therefore, the fourth groove 50 is a space portion.

Consequently, the wiring layer 230 (230') is formed and disposed on the insulating layer 131 (131'), and causes the compartment section 22d to electrically connect to the contact portion 20 of the second groove 19.

As a result, according to the modified example, since the insulating layer 131 is bridged between the surface of the compartment section 22a and the surface of the compartment section 22d, it is not necessary to form the insulating layer in the fourth groove 50, and it is possible to connect the compartment section 22d to the contact portion 20 which is exposed in the second groove 19.

Thus, short-circuiting between the wiring layer 230 and the top electrode 13 is prevented, and it is possible to obtain an effect which is similar to the above-described first embodiment.

### Fourth Embodiment not part of the invention

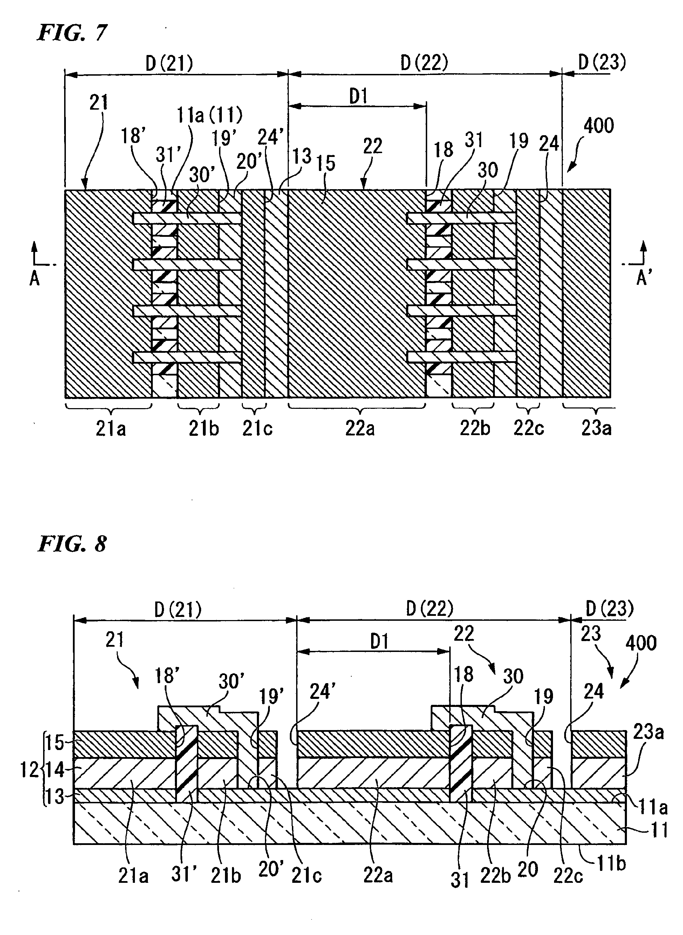

Next, a method for manufacturing an amorphous silicon solar cell in the case where the fourth groove 50 is not formed will be described with reference to FIGS. 7 to 9C.

In addition, in the explanation described below, identical symbols are used for the elements which are identical to those of the fourth embodiment, and the explanations thereof are omitted or simplified.

FIG. 7 is a plan view showing an amorphous silicon-type solar cell, and FIG. 8 is a cross-sectional view taken along the line A-A' of FIG. 1.

As shown in FIGS. 7 and 8, a solar cell 400 includes compartment elements 21, 22, and 23.

In addition, in the compartment element 22, the compartment section 22a corresponds to a first compartment section, the compartment section 22c corresponds to a second compartment section, and the compartment section 22b corresponds to an intermediate-compartment section.

In addition, in the compartment element 21, the compartment section 21a corresponds to a first compartment section, the compartment section 21 c corresponds to a second compartment section, and the compartment section 21b corresponds to an intermediate-compartment section.

In addition, in the compartment element 23, the compartment section 21a corresponds to a first compartment section.

### Amorphous Silicon Solar Cell

FIG. 7 is a plan view showing an amorphous silicon-type solar cell, and FIG. 8 is a cross-sectional view taken along the line A-A' of FIG. 7.

As shown in FIGS. 7 and 8, a solar cell 10 is a so-called single-type solar cell and has a structure in which a photoelectric converter 12 is formed on one face 11a (hereinafter, refer to back face 11a) of a transparent substrate 11 having an insulation property.

The substrate 11 is composed of an insulation material having an excellent sunlight transparency and durability such as a glass or a transparent resin, and a length of the substrate 11 is, for example, approximately 1 m.

In the solar cell 10, sunlight is incident to the side of the substrate 11 opposite to the photoelectric converter 12, that is, the other face of the substrate 11 (hereinafter, refer to top face 11b).

The photoelectric converter 12 has a structure in which a semiconductor layer (photoelectric conversion layer) 14 is held between a top electrode (first-electrode layer) 13 and a back electrode (second-electrode layer) 15, and is formed on the entire area of the back face 11a of the substrate 11 except for the periphery thereof.

The top electrode 13 is composed of a transparent electroconductive material, an oxide of metal having an optical transparency, for example, a so-called TCO (transparent conducting oxide) such as ITO (Indium Tin Oxide), FTO (Fluorine-doped Tin Oxide), and is formed on the back face 11a of the substrate 11 along with a surface-texture.

A semiconductor layer 14 is formed on the top electrode 13.

The semiconductor layer 14 has, for example, a pin-junction structure in which an i-type amorphous silicon film (not shown in the figure) is sandwiched between a p-type amorphous silicon film (not shown in the figure) and an n-type amorphous silicon film (not shown in the figure).

In the pin-junction structure, when sunlight is incident to the semiconductor layer 14, electrons and holes are generated and actively transfer due to a difference in the electrical potentials between the p-type amorphous silicon film and the n-type amorphous silicon film; and a difference in the electrical potentials between the top electrode 13 and the back electrode 15 is generated when the transfer thereof is continuously repeated (photoelectric conversion).

The back electrode 15 is composed of a metal film having relatively high electroconductive rate and reflectance, for example, Ag, Al, Cu, or the like, and is stacked on the semiconductor layer 14.

In addition, in order to improve, for example, the barrier property between the back electrode 15 and the semiconductor layer 14 and reflectance, it is preferable that a transparent electrode such as TCO (not shown in the figure) be formed between the back electrode 15 and the semiconductor layer 14.

Here, the photoelectric converter 12 formed on the substrate 11 is partitioned by a predetermined size due to a lot of third grooves 24.

Namely, a region D that is surrounded by the third grooves 24 and third grooves 24' adjacent to the third grooves 24 is repeatedly formed; therefore a plurality of rectangular-shaped compartment elements 21, 22, and 23 are formed as seen from the substrate 11 in a vertical direction.

In addition, a first groove 18 separates the top electrode 13, the semiconductor layer 14, and the back electrode 15 of the photoelectric converter 12 from each other, between a first portion of the compartment element 22 (hereinafter, refer to compartment section 22a) and a second portion of the compartment element 22 adjacent to the compartment section 22a (hereinafter, refer to compartment section 22b).

Furthermore, the second groove 19 separates the semiconductor layer 14 from the back electrode 15 of the photoelectric converter 12, between the compartment section 22b and a third portion of the compartment element 22 (hereinafter, refer to compartment section 22c).

Specifically, the first groove 18 is a groove that is cut in the thickness direction of the substrate 11 at each of end portions of the compartment sections 22a and 22b which are adjacent to each other so that the back face 11a of the substrate 11 is exposed thereto, and the width of the first groove 18 is, for example, approximately 20 to 60 µm.

Moreover, the compartment elements 21 and 23 have the structure D which is identical to the compartment element 22. However, in the case where it is necessary to distinguish between the compartment element 22 adjacent to the compartment elements 21 and 23, and the compartment elements 21 and 23, for convenience, a compartment element that is adjacent to the first groove 18 as seen from the compartment section 22b is shown as the compartment element 21, and a compartment element that is adjacent to the side of the third groove 24 is shown as the compartment element 23 in the drawings.

In addition, the constituent elements of the compartment element 21 corresponding to the first groove 18, the second groove 19, the contact portion 20, the third groove 24, the wiring layer 30, and an insulation paste (insulating layer) 31 which are the constituent elements of the compartment element 22, are shown as a first groove 18', a second groove 19', a contact portion 20', a third groove 24', a wiring layer 30', and an insulation paste (insulating layer) 31', respectively.

In the compartment element 22, a second groove 19 is formed adjacently to the first groove 18.

The second groove 19 is formed so that the compartment section 22b is sandwiched between the first groove 18 and the second groove 19.

The second grooves 19 are formed in the width direction of the first groove 18 with the distance therebetween, and are formed in substantially parallel to the longitudinal direction of the first groove 1C.

The second groove 19 penetrates through the back electrode 15 and the semiconductor layer 14 of the photoelectric converter 12 in the thickness direction of the substrate 11, and is formed so as to reach a portion at which the surface of the top electrode 13 is exposed.

The second groove 19 serves as a contact hole that electrically connects adjacent compartment elements 22 and 23 to each other.

The top electrode 13 that is exposed in the second groove 19 of the compartment element 22 functions as a contact portion 20.

Consequently, the back electrode 15 of the compartment section 22a is connected to the contact portion 20 of the top electrode 13 in the second groove 19 by a wiring layer 30 described below; therefore, the compartment elements 22 and 23 which are adjacent to each other are connected to each other in series.

In addition, the distance between the first groove 18 and the second groove 19 depends on a degree of alignment precision of a laser-processing apparatus, and is preferably a distance as narrow as possible so as to avoid a decrease in the effective area.

Specifically, it is the distance which does not make the first groove 18 and the second groove 19 contact each other, and is formed of, for example, preferably 1 to 500 µm, 10 to 200 µm, more-preferably approximately 10 to 150 µm.

Furthermore, in the compartment element 22, the above-described third groove 24 is formed at the side of the second groove 19 which is opposite to the first groove 18, that is, so as to be adjacent to the second groove 19.

The third grooves 24 are formed in the width direction of the second groove 19 with the distance therebetween, and are formed substantially parallel to the longitudinal direction of the first groove 18.

Similar to the second groove 19, the third groove 24 penetrates through the back electrode 15 and the semiconductor layer 14 of the photoelectric converter 12 in the thickness direction of the substrate 11, and is formed so as to reach a portion at which the surface of the top electrode 13 is exposed.

For this reason, it is possible to separate the back electrode 15 and the semiconductor layer 14 of the photoelectric converter 12 from the back electrode 15 and the semiconductor layer 14 of the compartment element 23, that is, it is possible to separate the compartment section 22c from the compartment section 23a.

Consequently, a region D1 (compartment section 22a) surrounded between the third groove 24' of the compartment element 21 and the first groove 18 of the compartment element 22 constitutes a power-generation effective region of the compartment element 22.

In addition, the distance between the second groove 19 and the third groove 24 in the identical compartment element 22, namely, the width of the compartment section 22c, depends on a degree of alignment precision of a laser-processing apparatus; it is necessary for the distance not to make the second groove 19 and the third groove 24 contact each other, that is, the distance makes the compartment section 22c separating between a plurality of cells to be reliably formed.

The distance is, for example, 1 to 100 µm, it is preferable that the distance be 1 to 60 µm, and it is further preferable that the distance be approximately 30 to 60 µm.

As described above, the above-described first groove 18, second groove 19, and third groove 24 are formed in parallel to each other along the longitudinal direction thereof.

Consequently, the first groove 18 penetrates the photoelectric converter 12 so as to reach a position that is exposed at the back face 11a of the substrate 11.

On the other hand, the second groove 19 and the third groove 24 penetrate the back electrode 15 and the semiconductor layer 14 so as to reach a position that is exposed at the top electrode 13.

That is, the top electrode 13 is formed on the entire area between the first grooves 18 which are adjacent to each other.

On the other hand, the semiconductor layer 14 and the back electrode 15 are separated by each of the first groove 18, the second groove 19, and the third groove 24 in each compartment element 22.

Here, the insulation paste 31 (insulating layer) is implanted into the above-described first groove 18.

The insulation pastes 31 are formed in the first grooves 18 in the longitudinal direction of the first groove 18 with the distance therebetween, and is formed so that the top of the insulation paste 31 protrudes from the surface of the back electrode 15 of the photoelectric converter 12 in the thickness direction of the insulation paste 31.

In addition, as a material used for the insulation paste 31, an ultraviolet-curable resin, a heat-curable resin, or the like having an insulation property can be used, for example, an acrylic-ultraviolet-curable resin (for example, ThreeBond 3042) is preferably used.

In addition, SOG (Spin on Glass) or the like can also be used in addition to the foregoing resin material.

In addition, the wiring layer 30 that covers the surface of the insulation paste 31 from the surface of the back electrode 15, and is led to the inside of the second groove 19, is formed on the surface of the back electrode 15.

The wiring layers are formed so as to correspond to each insulation paste 31, and are formed along the longitudinal direction of the first groove 18 with the distance therebetween similar to the insulation paste 31.

The wiring layer 30 is a layer electrically connecting the back electrode 15 of the compartment section 22a in the compartment element 22 to the top electrode 13 of the compartment section 23a in the compartment element 23, and is formed so as to bridge between the back electrode 15 of the compartment section 22a and the top electrode 13 of the compartment section 23a.

One end of the wiring layer 30 (first end) is connected to the surface of the back electrode 15 of the compartment section 22a, and the other end (second end) is connected to the contact portion 20 of the top electrode 13 which is exposed in the second groove 19.

With this configuration, the compartment section 22a of the compartment element 22 is connected to the compartment section 23a of the compartment element 23 in series.

The compartment section 23a of the compartment element 23 is formed so as to be lateral to the third groove 24 opposite to the compartment element 22.

Similarly, since the wiring layer 30' is formed, the compartment section 21a of the compartment element 21 is connected to the compartment section 22a of the compartment element 22 in series.

In addition, as a formation material of the wiring layer 30, material having an electroconductivity, for example, low-temperature firing type nano-ink metal (Ag) or the like is used.

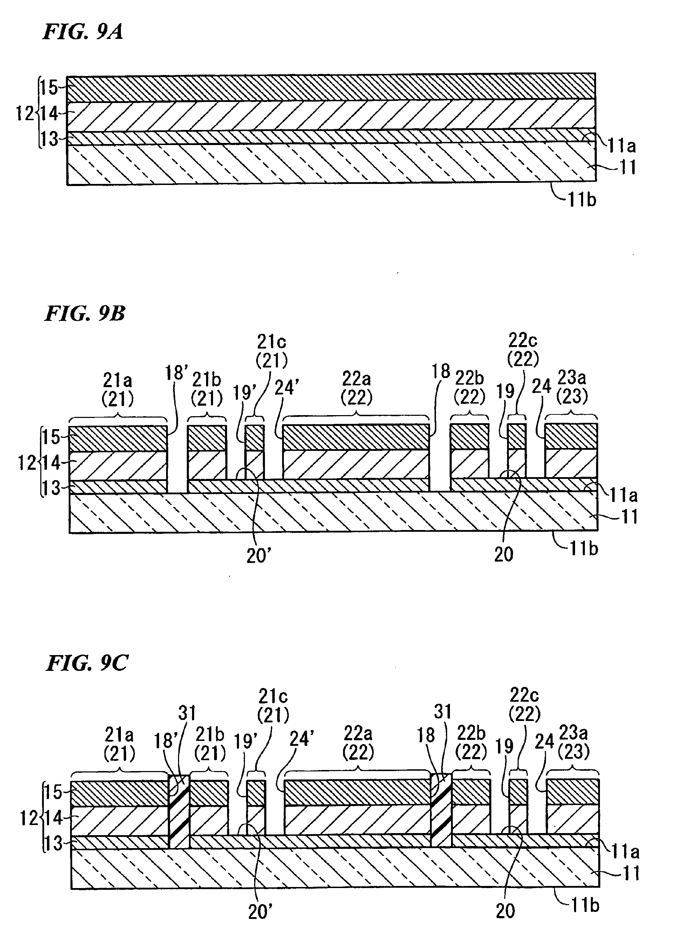

FIGS. 9A to 9C are cross-sectional views taken along the line A-A' of FIG. 7, and are flow sheets of the amorphous silicon solar cell.

Firstly, as shown in FIG. 9A, a photoelectric converter 12 is formed on the entire area of the back face 11a of the substrate 11 except for the periphery thereof (photoelectric converter forming step).

Specifically, a top electrode 13, a semiconductor layer 14, and a back electrode 15 are stacked in layers, in this order, on the back face 11a of the substrate 11 by a CVD method, a sputtering method, or the like.

Subsequently, as shown in FIG. 3B, the photoelectric converter 12 formed on the substrate 11 is partitioned by a predetermined size, and a compartment element 22 (compartment sections 22a, 22b, and 22c) is thereby formed (scribing step).

Additionally, a compartment element 21 (compartment sections 21a, 21b, and 2 1 c) and a compartment element 23 (for example, compartment section 23a, or the like) can be formed in a similar way.

Here, in the fourth embodiment, a first groove 18, a second groove 19, and a third groove 24 are simultaneously formed by use of a laser-processing apparatus (not shown in the figure) irradiating the substrate 11 with lasers having two or more wavelengths (not shown in the figure).

Three laser light sources irradiating with lasers in order to form three grooves are arranged in the laser-processing apparatus.

Specifically, the relative positions which include the position irradiated with a first laser (not shown in the figure) forming the first groove 18, the position irradiated with a second laser (not shown in the figure) forming the second groove 19, and the position irradiated with a third laser (not shown in the figure) forming the third groove 24, are fixed.

As a laser of the fourth embodiment, a pulsed YAG (Yittrium Aluminium Garnet) laser or the like can be used.

It is preferable that, for example, an infrared laser (IR: infrared laser) having a wavelength of 1064 nm be used as the laser forming the first groove 18.

In addition, it is preferable that a SHG (second harmonic generation) laser having a wavelength of 532 nm be used as the lasers forming the second groove 19 and the third groove 24.

In the laser-processing apparatus, the substrate 11 is simultaneously scanned along a surface thereof with the lasers forming the first groove 18, the second groove 19, and the third groove 24 onto a top face 11b of the substrate 11 toward the photoelectric converter 12.

Because of this, in the region that is irradiated with the laser having a wavelength of 1064 nm, the laser heats up the top electrode 13 and the top electrode 13 evaporates.

Consequently, the semiconductor layer 14 and the back electrode 15 which are stacked in layers on the top electrode 13 of the region that is irradiated with the laser are removed by an expansive force top generated in the electrode 13.

For this reason, in the region that is irradiated with the laser having a wavelength of 1064 nm, the first groove 18, to which the back face 11a of the substrate 11 is exposed, is formed.

In contrast, in the region that is irradiated with the laser having a wavelength of 532 nm, the laser heats up the semiconductor layer 14 and the semiconductor layer 14 evaporates.

Consequently, the back electrode 15 which is stacked in layers on the semiconductor layer 14 of the region that is irradiated with the laser is removed by an expansive force of the semiconductor layer 14.

For this reason, in the region that is irradiated with the laser having a wavelength of 532 nm, the second groove 19 and the third groove 24 to which the surface of the top electrode 13 is exposed, are formed.

As a result, the first groove 18, the second groove 19, and the third groove 24 are formed in parallel to each other along the longitudinal direction, a compartment element 22 which is separated by a predetermined size and which has a power-generation effective region D1 (compartment section 22a) is formed between adjacent third grooves 24 and 24'.

At this time, the top electrode 13 is formed on the entire area between the first grooves 18 and 18' which are adjacent to each other.

On the other hand, the semiconductor layer 14 and the back electrode 15 are separated by each of the first grooves 18 and 18', the second grooves 19 and 19', and the third grooves 24 and 24' of each of the compartment elements 21, 22, and 23.

Next, as shown in FIG. 9C, an insulating layer 31 is formed in the first groove 18 using an inkjet method, a screen printing method, a dispensing method, or the like (insulating-layer forming step).

As the formation material of the insulating layer 31, for example, insulation paste is used.

In addition, in the case of forming the insulating layer 31 using an inkjet method, an inkjet head ejecting the formation material of the insulating layer 31 and the substrate 11 (body to be processed) on which the photoelectric converter 12 is formed are relatively transferred, and the formation material of the insulating layer 31 is dropped on the substrate 11 from the inkjet head.

Specifically, inkjet heads (nozzles of inkjet head) are arrayed in a direction orthogonal to the longitudinal direction of the first groove 18, that is, corresponding to the distance between the first grooves 18; and the formation material of the insulating layer 31 is applied on the substrate 11 while scanning with the inkjet heads along the longitudinal direction of the first groove 18.

Also, a plurality of heads may be arrayed along the longitudinal direction of the first groove 18, and the formation material of the insulating layer 31 may be applied to each of the first grooves 18 of a plurality of compartment elements 21, 22, and 23 at the same time.

Consequently, after the formation material of the insulating layer 31 is applied to the inside of the first groove 18, the material of the insulating layer 31 is cured.

Specifically, in the case where an ultraviolet-curable resin is used as the material of the insulating layer 31, the formation material of the insulating layer 31 is cured by irradiating the formation material of the insulating layer with ultraviolet light.

On the other hand, in the case where a heat-curable resin or SOG is used as the formation material of the insulating layer 31, the formation material of the insulating layer 31 is cured by baking the formation material of the insulating layer.

Because of this, the insulating layer 31 is formed in the first groove 18.

As described above, it is possible to insulate between the compartment sections 22a and 22b by forming the insulating layer 31 in the first groove 18 in the insulating-layer forming step.

Consequently, between the compartment sections 22a and 22b, adjacent top electrodes 13 are not in contact with each other, and adjacent semiconductor layers 14 are not in contact with each other.

For this reason, between the compartment sections 22a and 22b, it is possible to reliably suppress the generation of leakage current or the like which is caused by short-circuiting between the top electrodes 13 and between the semiconductor layers 14.

Subsequently, a wiring layer 30 is formed.

Specifically, the formation material of the wiring layer 30 is applied using an inkjet method, a screen printing method, a dispensing method, soldering, or the like, therefore, the wiring layer 30 reaches the contact portion 20 of the top electrode 13 that is exposed in the second groove 19, through the surface of the insulating layer 31, from the surface of the back electrode 15 of the compartment section 22a.

Consequently, after applying the formation material of the wiring layer 30, the formation material of the wiring layer 30 is baked and the wiring layer 30 is cured.

In addition, in the case where a heat-curable resin or SOG is used as the above-described formation material of the insulating layer 31, it is possible to perform curing the insulating layer 31 and curing the wiring layer 30 at the same time, and it is possible to improve the manufacturing efficiency.

In the above-described manner, the wiring layer 30 is formed on the insulating layer 31, the back electrode 15 of the compartment section 22a is connected to the top electrode 13 of the contact portion 20 by the wiring layer 30, therefore, it is possible to connect the compartment elements 22 and 23 which are adjacent to each other in series in addition to ensuring insulation between the compartment sections 22a and 22b.

Because of this, it is possible to prevent the compartment elements 22 and 23 from being short-circuited to each other, it is possible to improve the power generation efficiency.

As described above, as shown in FIGS. 7 and 8, the amorphous silicon-type solar cell 10 of the fourth embodiment is completed.

In the above-described fourth embodiment, a method for simultaneously forming the first groove 18, the second groove 19, and the third groove 24 is used in the scribing step.

According to this method, since each of the grooves 18, 19, and 24 is simultaneously formed in the photoelectric converter 12 from the top face 11b of the substrate 11 after the photoelectric converter 12 is formed on the substrate 11, it is possible to form each of the grooves 18, 19, and 24 with a high degree of precision.

That is, due to simultaneously forming each of the grooves 18, 19, and 24 by simultaneously scanning with each laser, it is possible to perform the scribing while maintaining the relative positions of the grooves 18, 19, and 24 in the scribing step.

Consequently, since the relative positions of the grooves 18, 19, and 24 are not misaligned, adjacent grooves (for example, between the first groove 18 and the second groove 19) are prevented from being in contact with each other, and it is possible to form each groove with a high degree of precision.

Consequently, since it is possible to perform the scribing with a high degree of precision even on a large-scale substrate 11, it is possible to reliably separate the compartment sections 22a, 22b, and 22c from each other, and it is possible to reliably prevent adjacent grooves from being in contact with each other.

Because of this, since it is possible to ensure insulation between the compartment section 22a having the power-generation effective region D1, and the compartment 21d adjacent to the compartment section 22a, it is possible to suppress degradation of the power generation efficiency due to short-circuiting between the compartment sections 22a and 22b.

Consequently, by forming each of the grooves 18, 19, and 24 with a high degree of precision, it is possible to more reduce the distance between adjacent grooves 18, 19, and 24 than before.

For this reason, since it is possible to increase an area of the power-generation effective region D 1 (for example, compartment section 22d) of each of the compartment elements 21, 22, and 23, it is possible to improve the power generation efficiency of each compartment element D.

In this case, by simultaneously forming each of the grooves 18, 19, and 24 in the photoelectric converter 12 from the top face 11b of the substrate 11 after the photoelectric converter 12 is formed on the substrate 11, it is possible to easily form each of the grooves 18, 19, and 24, compared to conventional cases where the scribing is performed in every step for forming each layer, and it is possible to improve the manufacturing efficiency.

### Fifth Embodiment not part of the invention

Next, the fifth embodiment not part of the present invention will be described.

In addition, in the explanation described below, identical symbols are used for the elements which are identical to those of the fourth embodiment, and the explanations thereof are omitted or simplified.

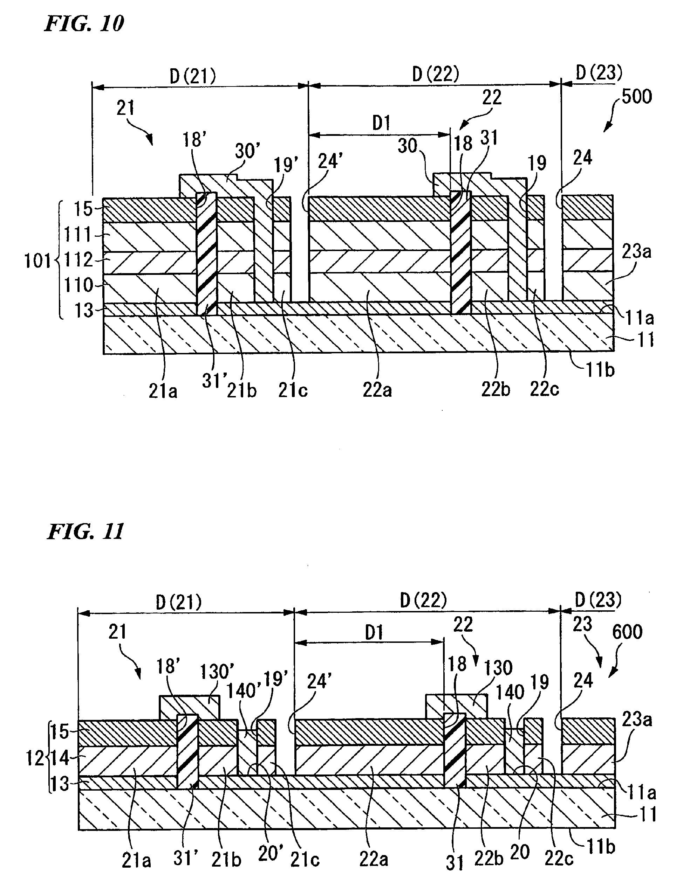

FIG. 10 is a cross-sectional view taken along the line A-A' of FIG. 7, and is a cross-sectional view showing a tandem-type solar cell.

The fifth embodiment is different from the above-described fourth embodiment, in the sense of a so-called tandem-type solar cell being employed in which a first semiconductor layer composed of an amorphous silicon film and a second semiconductor layer composed of a microcrystalline silicon film are held between a pair of electrodes.

As shown in FIG. 10, a solar cell 500 has a structure in which a photoelectric converter 101 is formed on the back face 11a of the substrate 11.

The photoelectric converter 101 is configured so that the top electrode 13 formed on the back face 11a of the substrate 11, a first semiconductor layer 110 composed of amorphous silicon, an intermediate electrode 112 composed of TCO or the like, a second semiconductor layer 111 composed of microcrystalline silicon, and the back electrode 15 composed of a metal film are sequentially stacked in layers.

The first semiconductor layer 110 forms a pin-junction structure in which an i-type amorphous silicon film (not shown in the figure) is sandwiched between a p-type amorphous silicon film (not shown in the figure) similar to the above-described semiconductor layer 14 (with reference to FIG. 8) and an n-type amorphous silicon film (not shown in the figure).

In addition, the second semiconductor layer 111 forms a pin-junction structure in which an i-type microcrystalline silicon film (not shown in the figure) is sandwiched between a p-type microcrystalline silicon film (not shown in the figure) and an n-type microcrystalline silicon film (not shown in the figure).

Here, the first groove 18 penetrating through the top electrode 13 of the photoelectric converter 101, the first semiconductor layer 110, the intermediate electrode 112, the second semiconductor layer 111, and the back electrode 15 is formed in the photoelectric converter 101.

Similar to the above-described fourth embodiment, the first groove 18 is formed so as to expose the back face 11a of the substrate 11.

In addition, the second groove 19 is formed adjacent to the first groove 18.

The second groove 19 is formed so as to penetrate through the first semiconductor layer 110 of the photoelectric converter 101, the intermediate electrode 112, the second semiconductor layer 111 in the thickness direction of the substrate 11, and the back electrode 15, and so as to reach the position at which the surface of the top electrode 13 is exposed, in a manner similar to the above-described fourth embodiment.

Furthermore, the third groove 24 is formed lateral to the second groove 19 opposite to the first groove 18.

The third groove 24 is formed so as to penetrate through the first semiconductor layer 110 of the photoelectric converter 101, the intermediate electrode 112, the second semiconductor layer 111, and the back electrode 15 in the thickness direction of the substrate 11 and so as to reach the position at which the surface of the top electrode 13 is exposed, in a manner similar to the above-described fourth embodiment.

Consequently, a region D that is surrounded between the third grooves 24 and 24' is repeatedly formed, therefore, a plurality of rectangular-shaped compartment elements 21, 22, and 23 are formed as seen from the substrate 11 in a vertical direction.

As described above, in the fifth embodiment, the above-described first groove 18, second groove 19, and third groove 24 are also formed in parallel to each other along the longitudinal direction thereof.

Consequently, the first groove 18 is formed so as to reach a position that is exposed at the back face 11a of the substrate 11.

On the other hand, the second groove 19 and the third groove 24 are formed so as to reach a position that is exposed at the top electrode 13.

That is, the top electrode 13 is formed on the entire area between the first grooves 18 which are adjacent to each other.

On the other hand, the back electrode 15, the first semiconductor layer 110, and the second semiconductor layer 111 are separated by each of the second groove 19 and third groove 24 of the compartment elements 21, 22, and 23.

Here, the insulating layer 31 is formed in the first groove 18.

The insulating layers 31 are formed in the first groove 18 with the distance therebetween in the longitudinal direction of the first groove 18, and are formed so that the top of the insulating layer 31 protrudes from the surface of the back electrode 15 of the photoelectric converter 101 in the thickness direction of the insulating layer 31.

In addition, the wiring layer 30 that covers the surface of the insulating layers 31 from the surface of the back electrode 15, and is led to the inside of the second groove 19, is formed on the surface of the back electrode 15.

The wiring layer 30 is formed so as to correspond to each position of the insulating layer 31, and formed along the longitudinal direction of the first groove 18 with the distance therebetween in similar to the insulating layer 31.

As described above, the solar cell 500 of the fifth embodiment is a tandem-type solar cell in which a-Si and microcrystalline Si are stacked in layers.

According to the fifth embodiment, it is possible to obtain the same actions and effects as the above-described fourth embodiment.

Furthermore, since the solar cell 500 having the tandem structure absorbs short-wavelength light by the first semiconductor layer 110, and long-wavelength light by the second semiconductor layer 111, it is possible to improve the power generation efficiency.

In addition, due to providing the intermediate electrode 112 between the first semiconductor layer 110 and the second semiconductor layer 111, since part of light passing through the first semiconductor layer 110 and reaching the second semiconductor layer 111 is reflected at the intermediate electrode 112 and is incident to the first semiconductor layer 110 again, the sensitivity of the photoelectric converter 101 is improved while contributing to the improvement of the power generation efficiency.

In addition, in the above-described fifth embodiment, the case where the intermediate electrode 112 is employed is described, a structure in which an intermediate electrode 112 is not provided can be also adopted.

### Sixth Embodiment not part of the invention

Next, the sixth embodiment not part of the present invention will be described.

In addition, in the explanation described below, identical symbols are used for the elements which are identical to those of the fourth embodiment, and the explanations thereof are omitted or simplified.

FIG. 11 is a cross-sectional view taken along the line A-A' of FIG. 7, and is a cross-sectional view showing a single-type solar cell of a sixth embodiment.

As shown in FIG. 11, the solar cell 600 of the sixth embodiment is provided with a first wiring layer 130 connecting the back electrode 15 of the compartment section 22a to the back electrode 15 of the compartment section 22b, and a second wiring layer 140 connecting the contact portion 20 to the back electrode 15 of the compartment section 22b.

The first wiring layer 130 passes through the surface of the insulating layer 31 from the surface of the back electrode 15 of the compartment section 22a and reaches the surface of the back electrode 15 of the compartment section 22b, and is formed so as to bridge between the compartment sections 22a and 22b.

That is, one end of the first wiring layer 130 (first end) is connected to the surface of the back electrode 15 of the compartment section 22a, on the other hand, the other end (second end) is connected to the surface of the back electrode 15 of the compartment section 22b.

The first wiring layer 130 is formed so as to correspond to each position of the insulating layers 31.

For example, in the case where the insulating layer 31 is formed on the entire area of the first groove 18 in the longitudinal direction thereof, the first wiring layer 130 may be formed on the entire area of the insulating layer 31 or on the insulating layer 31 with the distance therebetween in the longitudinal direction thereof.

In addition, in the case where the insulating layers 31 are formed along the longitudinal direction of the first groove 18 with the distance therebetween, it may be formed along the longitudinal direction of the first groove 18 with the distance therebetween in manner to the insulating layer 31.

The second wiring layer 140 is formed so as to be implanted into the second groove 19, and reaches the position which is in contact with the back electrode 15 from the contact portion 20 (bottom face) which is exposed in the second groove 19.

Consequently, top electrode 13 which is exposed at the contact portion 20 is connected to the back electrode 15 of the compartment section 22b.

Moreover, the second wiring layer 140 may protrude from the surface of the back electrode 15, or it is not necessary to protrude therefrom, as long as the second wiring layer 140 is formed so as to reach the side which is closer to the back electrode 15 than the boundary portion between the semiconductor layer 14 and the back electrode 15, that is, the position at which the back electrode 15 is disposed in the thickness direction of the solar cell 600.

The second wiring layer 140 is formed along the longitudinal direction of the second groove 19 with the distance therebetween.

Additionally, it is not necessary for the distance between the second wiring layers 140 to coincide with the distance between the first wiring layers 130 along the longitudinal direction of the first groove 18.

In addition, the second wiring layer 140 may be formed at the entire area along the longitudinal direction of the second groove 19.

Because of this, the first wiring layer 130 and the second wiring layer 140 are mutually connected to the back electrode 15 of the compartment section 22b, and the first wiring layer 130 is electrically connected to the second wiring layer 140 with the back electrode 15 of the compartment section 22b interposed therebetween.

Consequently, the compartment section 22b of the compartment element 22 is connected to the compartment section 23 a of the compartment element 23 in series.

The compartment section 23a of the compartment element 23 is formed so as to be lateral to the third groove 24 opposite to the compartment element 22.

Similarly, due to the first wiring layer 130' and the second wiring layer 140', the compartment section 21b of the compartment element 21 is connected to the compartment section 22a of the compartment element 22 in series.

Therefore, according to the sixth embodiment, since the first wiring layer 130 and the second wiring layer 140 are mutually connected to the back electrode 15 of the compartment section 22b, it is possible to electrically connect the first wiring layer 130 to the second wiring layer 140 by the back electrode 15, in addition to obtaining the same actions and effects as the above-described fourth embodiment.

For this reason, unlike the fourth embodiment, since it is not necessary to continuously form the wiring layer 30 (refer to FIG. 8) from the back electrode 15 of the compartment section 22a to the contact portion 20, it is possible to reduce the cost of the material of a wiring layer.

In addition, since it is not necessary for the distance between the first wiring layer 130 and the second wiring layer 140 to coincide with, for example, the longitudinal direction of the first groove 18, it is possible to improve the manufacturing efficiency.

However, in the above-described solar cells 400, 500, and 600 of the fourth to the sixth embodiments, it is impossible to separate the portions which are affected by heat due to an infrared laser, from an effective power generation region.

In contrast, in the above-described solar cells 10, 100, and 200 of the first to the third embodiments, fourth groove 50 is formed, and the first groove 18 is separated from the power-generation effective region D1.

As a result, the solar cells of the first to the third embodiments can obtain excellent photoelectric conversion efficiency more than that of the solar cells of the fourth to the sixth embodiments.

In addition, the technical scope of the invention is not limited to the above embodiments, but various modifications may be made without departing from the scope of the invention.

Namely, the above-described embodiment constitutions or the like are examples, modifications can be appropriately adopted.

For example, in the above-described embodiments, a single-type and a tandem-type solar cells are described, the structure of the present invention can be applied to a so-called triple-type solar cell in which amorphous silicon film, amorphous silicon film, and microcrystalline silicon film are held between a pair of electrodes.

In addition, in the above-described the first to the third embodiments, the insulating layers are formed in the first groove and the fourth groove in the longitudinal direction of the first groove and the fourth groove with the distance, the insulating layers may be formed in the entire area of the first groove and the fourth groove.

In this case, the wiring layers formed on the insulating layer may be continuously formed along the longitudinal direction of the first groove without a distance therebetween.

In addition, it is not necessary for the insulating layer to protrude from the surface of the photoelectric converter (back electrode), but it is necessary to insulate between the top electrode and the semiconductor layer of at least adjacent compartment elements.

Furthermore, in the above-described the first to the third embodiments, the cases of simultaneously form the first to the fourth grooves with the first to the fourth lasers are described, the present invention is not limited to this.

As long as a fourth groove is formed previous to or at the same time of forming a first groove, a second groove and a third groove may be formed anytime.

For example, after the second to the fourth grooves that separate the back electrode from the semiconductor layer are simultaneously formed, the first groove that separates the top electrode, the back electrode, and the semiconductor layer from each other can be formed.

Additionally, a fourth groove is only formed in advance, thereafter, the first to the third grooves may be formed.

According to the above-described structures, the compartment that was preliminarily separated from an effective power generation region with a second harmonic of an infrared laser which is less affected by heat is thereafter scanned with an infrared laser, it is possible to reliably further prevent influences caused by heat due to an infrared laser from being propagated, and it is possible to improve the photoelectric conversion efficiency of each compartment element.

In addition, in the above-described first to sixth embodiments, a method in which three light sources or four light sources are used when forming three grooves or four grooves is described.

That is, in the first to the sixth embodiments, the number of laser light sources coincides with the number of grooves, but the present invention is not limited to this.

For example, the number of laser light sources may be less than the number of grooves.

Specifically, due to using a laser light source that is capable of using while switching an infrared laser and a visible laser, namely, a laser light source that is capable of selecting one from a plurality of wavelengths, it is possible to form a plurality of grooves by one or two laser light sources.

It is believed that two light sources are employed such that one thereof is an infrared laser and the other is a visible laser.

As described above, in the case of forming three or more grooves by use of one or two light sources, the number of scanning the substrate 11 with the lasers is multiple time.

On the other hand, in the case of using three light sources or four light sources, the lasers scan the substrate 11 once.

As a result, in the case of using three light sources or four light sources, it is possible to eliminate the number of scanning times with the lasers, compared to forming three or more grooves by use of one or two light sources, and it is possible to realize shortening of the tact time.

### Industrial Applicability

As described above in detail, the present invention is applicable to a solar cell and a method for manufacturing the solar cell, which shortens the length of required time for a laser scribing step, which suppresses the influences caused by heat generation at the time of scribing, and in which it is possible to improve the photoelectric conversion efficiency.

## Claims

1. A method for manufacturing a solar cell, the method comprising a scribing step in which grooves (18, 19, 24, 50) electrically-separating a photoelectric converter (12) into a plurality of compartment sections (21, 22, 23) are formed after the photoelectric converter (12) is formed on a substrate (11) by stacking a first-electrode layer (13), a photoelectric conversion layer (14), and a second-electrode layer (15) in this order, wherein
in the scribing step,
a first groove (18) is formed which penetrates through the first-electrode layer (13), the photoelectric conversion layer (14), and the second-electrode layer (15), and which separates the first-electrode layer (13), the photoelectric conversion layer (14), and the second-electrode layer (15) into a first compartment section (21a, 22a, 23a) and a second compartment section (21b, 22b, 23b),
a second groove (19) is formed parallel to the first groove (18), the second groove (19) penetrates through the photoelectric conversion layer (14) and the second-electrode layer (15), and the second groove (19) separates the photoelectric conversion layer (14) and the second-electrode layer (15) into the second compartment section (21b, 22b, 23b) and a third compartment section (21c, 22c, 23c),
a third groove (24) is formed parallel to the first groove (18) and is lateral to the second groove (19) opposite to the first groove (18) adjacent to the second groove (19), the third groove (24) penetrates through the photoelectric conversion layer (14) and the second-electrode layer (15), and the third groove (24) separates the photoelectric conversion layer (14) and the second-electrode layer (15) into the third compartment section (21 c, 22c, 23c) and a fourth compartment section (21 d, 22d, 23d), and
a fourth groove (50) is formed parallel to the first groove (18), lateral to the first groove (18) opposite to the second groove (19), the fourth groove (50) penetrates through the photoelectric conversion layer (14) and the second-electrode layer (15), and the fourth groove (50) separates at least the photoelectric conversion layer (14) and the second-electrode layer (15) into the fourth compartment section (21d, 22d, 23d) and the first compartment section (21a, 22a, 23a) between the first groove (18) and the fourth compartment section (21d, 22d, 23d) that becomes a power-generation effective region (D1), wherein
the method comprises :
an insulating-layer forming step in which an insulating layer (31, 51) is formed inside the first groove (18) and the fourth groove (50) after the scribing step; and
a wiring-layer forming step in which a wiring layer (30) electrically connecting the plurality of compartment sections (21, 22, 23) to each other is formed, and wherein
in the wiring-layer forming step, the wiring layer (30) passes from the first-electrode layer (13) that is exposed at a bottom face of the second groove (19), through the inside of the second groove (19) and a surface of the insulating layer (31, 51), to a surface of the second-electrode layer (15) that is disposed so as to be lateral to the fourth groove (50) opposite to the second groove (19), and the wiring layer (30) electrically connects the plurality of compartment sections (21, 22, 23) to each other.

2. The method for manufacturing a solar cell according to claim 1, wherein
an infrared laser is used as a first laser forming the first groove (18);
a visible laser is used as a second laser forming the second groove (19), a third laser forming the third groove (24), and a fourth laser forming the fourth groove (50); and
in the scribing step, each of the lasers are scanned so that a position irradiated with a first laser, a position irradiated with a second laser, a position irradiated with a third laser, and a position irradiated with a fourth laser are positioned parallel to each other with desired distances therebetween in the photoelectric converter (12), and thereby forming each of the grooves (18, 19, 24, 50).

3. The method for manufacturing a solar cell according to claim 2, wherein
in the scribing step, relative positions of the first laser, the second laser, the third laser, and the fourth laser are fixed, and each groove (18, 19, 24, 50) is formed and scanned with each laser.

4. The method for manufacturing a solar cell according to claim 3, wherein
in the scribing step, relative positions of the second laser, the third laser, and the fourth laser are fixed, and
the first groove (18) is formed and scanned with the first laser after the second groove (19), the third groove (24), and the fourth groove (50) are formed and scanned with each laser at the same time.

5. The method for manufacturing a solar cell according to claim 3, wherein
in the scribing step, relative positions of the first laser, the second laser, the third laser, and the fourth laser are fixed, and each groove (18, 19, 24, 50) is formed at the same time by scanning each laser simultaneously.

6. A solar cell comprising:
a photoelectric converter (12) in which a first-electrode layer (13), a photoelectric conversion layer (14), and a second-electrode layer (15) are stacked in layers in this order, the photoelectric converter (12) being formed on a substrate (11); and
grooves (18, 19, 24, 50) electrically separating the photoelectric converter (12) into a plurality of compartment sections (21, 22, 23), wherein
the grooves (18, 19, 24, 50) include:
a first groove (18) penetrating through the first-electrode layer (13), the photoelectric conversion layer (14), and the second-electrode layer (15), and separating the first-electrode layer (13), the photoelectric conversion layer (14), and the second-electrode layer (15) into a first compartment section (21 a, 22a, 23a) and a second compartment section (21 b, 22b, 23b);
a second groove (19) in which a wiring layer (30) electrically connecting the plurality of compartment sections (21, 22, 23) to each other is formed, the second groove (19) being parallel to the first groove (18) and the second groove (19) penetrating through the photoelectric conversion layer (14) and the second-electrode layer (15), and separating the photoelectric conversion layer (14) and the second-electrode layer (15) into the second compartment section (21 b, 22b, 23b) and a third compartment section (21c, 22c, 23c);
a third groove (24) being parallel to the first groove (18) and lateral to the second groove (19) opposite to the first groove (18) adjacent to the second groove (19), the third groove (24) penetrating through the photoelectric conversion layer (14) and the second-electrode layer (15), and separating the photoelectric conversion layer (14) and the second-electrode layer (15) into the third compartment section (21c, 22c, 23c) and a fourth compartment section (21d, 22d, 23d); and
a fourth groove (50) being parallel to the first groove (18), lateral to the first groove (18) opposite to the second groove (19), the fourth groove (50) penetrating through the photoelectric conversion layer (14) and the second-electrode layer (15), and separating at least the photoelectric conversion layer (14) and the second-electrode layer (15) into the fourth compartment section (21d, 22d, 23d) and the first compartment section (21 a, 22a, 23a) between the first groove (18) and the fourth compartment section (21d, 22d, 23d) that becomes a power-generation effective region (D1), and wherein
an insulating layer (31, 51) insulating at least the first-electrode layer (13) from the photoelectric conversion layer (14) between the compartment sections (21, 22, 23) adjacent to each other is formed inside the first groove (18);
an insulating layer (31, 51) insulating at least the photoelectric conversion layer (14) from the second-electrode layer (15) between the compartment sections (21, 22, 23) adjacent to each other is formed inside the fourth groove (50); and
the wiring layer (30) passes from the first-electrode layer (13) that is exposed at a bottom face of the second groove (19), through the inside of the second groove (19) and a surface of the insulating layer (31, 51), to a surface of the second-electrode layer (15) that is disposed so as to be lateral to the fourth groove (50) opposite to the second groove (19), and the wiring layer (30) electrically connects the plurality of compartment sections (21, 22, 23) to each other.

## Patentansprüche

1. Verfahren zum Herstellen einer Solarzelle, wobei das Verfahren einen Ritzschritt umfasst, in dem Nuten (18, 19, 24, 50), die einen photoelektrischen Wandler (12) elektrisch in eine Mehrzahl von Kammerabschnitten (21, 22, 23) trennen, gebildet werden, nachdem der photoelektrische Wandler (12) durch Stapeln einer Erste-Elektrode-Schicht (13) einer photoelektrischen Wandlungsschicht (14) und einer Zweite-Elektrode-Schicht (15) in dieser Reihenfolge auf einem Substrat (11) gebildet wird, wobei
in dem Ritzschritt,
eine erste Nut (18) gebildet wird, die die Erste-Elektrode-Schicht (13), die photoelektrische Wandlungsschicht (14) und die Zweite-Elektrode-Schicht (15) durchdringt, und die die Erste-Elektrode-Schicht (13), die photoelektrische Wandlungsschicht (14) und die Zweite-Elektrode-Schicht (15) in einem ersten Kammerabschnitt (21a, 22a, 23a) und einem zweiten Kammerabschnitt (21b, 22b, 23b) trennt,
eine zweite Nut (19) parallel zu der ersten Nut (18) gebildet wird, wobei die zweite Nut (19) die photoelektrische Wandlungsschicht (14) und die Zweite-Elektrode-Schicht (15) durchdringt, und wobei die zweite Nut (19) die photoelektrische Wandlungsschicht (14) und die Zweite-Elektrode-Schicht (15) in den zweiten Kammerabschnitt (21b, 22b, 23b) und einen dritten Kammerabschnitt (21c, 22c, 23c) trennt,
eine dritte Nut (24) parallel zu der ersten Nut (18) gebildet wird, wobei sie lateral zu der zweiten Nut (19) auf der der ersten Nut (18), die benachbart zu der zweiten Nut (19) ist, gegenüberliegenden Seite ist, wobei die dritte Nut (24) die photoelektrische Wandlungsschicht (14) und die Zweite-Elektrode-Schicht (15) durchdringt, und wobei die dritte Nut (24) die photoelektrische Wandlungsschicht (14) und die Zweite-Elektrode-Schicht (15) in den dritten Kammerabschnitt (21c, 22c, 23c) und einen vierten Kammerabschnitt (21 d, 22d, 23d) trennt,
eine vierte Nut (50) parallel zu der ersten Nut (18) gebildet wird, lateral zu der ersten Nut (18) auf der der zweiten Nut (19) gegenüberliegenden Seite, wobei die vierte Nut (15) die photoelektrische Wandlungsschicht (14) und die Zweite-Elektrode-Schicht (15) durchdringt, und wobei die vierte Nut (15) zumindest die photoelektrische Wandlungsschicht (14) und die Zweite-Elektrode-Schicht (15) in den vierten Kammerabschnitt (21d, 22d, 23d) und den ersten Kammerabschnitt (21a, 22a, 23a) zwischen der ersten Nut (18) und dem vierten Kammerabschnitt (21d, 22d, 23d), der ein effektiver Bereich (D1) zur Energieerzeugung wird, trennt, wobei
das Verfahren umfasst:
einen Isolierschichtbildungsschrift, in dem eine Isolierschicht (31, 51) innerhalb der ersten Nut (18) und der vierten Nut (50) nach dem Ritzschritt gebildet wird; und
einen Verdrahtungsschichtbildungsschritt, wobei die Verdrahtungsschicht (30) von der Erste-Elektrode-Schicht (13), die an einer unteren Fläche der zweiten Nut (19) freiliegt, durch das Innere der zweiten Nut (19) und eine Oberfläche der Isolierschicht (31, 51), zu einer Oberfläche der Zweite-Elektrode-Schicht (15), die so angeordnet ist, dass sie lateral zu der vierten Nut (50) auf der der zweiten Nut (19) gegenüberliegenden Seite ist, verläuft, und die Verdrahtungsschicht (30) die Mehrzahl von Kammerabschnitten (21, 22, 23) elektrisch miteinander verbindet.

2. Verfahren zum Herstellen einer Solarzelle nach Anspruch 1, wobei
ein Infrarotlaser als ein erster Laser, der die erste Nut (18) bildet, genutzt wird;
ein sichtbarer Laser als ein zweiter Laser, der die zweite Nut (19) bildet, ein dritter Laser, der die dritte Nut (24) bildet, und ein vierter Laser, der die vierte Nut (50) bildet, genutzt wird; und
in dem Ritzschritt, jeder der Laser so gescannt wird, dass eine Position, die mit einem ersten Laser bestrahlt wird, eine Position, die mit einem zweiten Laser bestrahlt wird, eine Position, die mit einem dritten Laser bestrahlt wird, und eine Position, die mit einem vierten Laser bestrahlt wird, parallel zueinander mit gewünschten Abständen dazwischen in dem photoelektrischen Wandler (12) positioniert sind, und dadurch jeder der Nuten (18, 19, 24, 50) gebildet wird.

3. Verfahren zum Herstellen einer Solarzelle nach Anspruch 2, wobei
in dem Ritzschritt, relative Positionen des ersten Lasers, des zweiten Lasers, des dritten Laser und des vierten Lasers festgelegt sind, und jede Nut (18, 19, 24, 50) mit jedem Laser gebildet und gescannt wird.

4. Verfahren zum Herstellen einer Solarzelle nach Anspruch 3, wobei
in dem Ritzschritt, relative Positionen des zweiten Lasers, des dritten Lasers und des vierten Lasers festgelegt sind, und
die erste Nut (18) mit dem ersten Laser gebildet und gescannt wird, nachdem die zweite Nut (19), die dritte Nut (24) und die vierte Nut (50) mit jedem Laser zur selben Zeit gebildet und gescannt werden.

5. Verfahren zum Herstellen einer Solarzelle nach Anspruch 3, wobei
in dem Ritzschritt, relative Positionen des ersten Lasers, des zweiten Lasers, des dritten Lasers und des vierten Lasers festgelegt sind, und jede Nut (18, 19, 24, 50) zur selben Zeit durch simultanes Scannen jedes Lasers gebildet werden.

6. Solarzelle, umfassend:
einen photoelektrischen Wandler (12), in dem eine Erste-Elektrode-Schicht (13), eine photoelektrische Wandlungsschicht (14) und eine Zweite-Elektrode-Schicht (15) in dieser Reihenfolge in Schichten gestapelt sind, wobei der photoelektrische Wandler (12) auf einem Substrat (11) gebildet ist; und
Nuten (18, 19, 24, 50), die den photoelektrischen Wandler (12) elektrisch in eine Mehrzahl von Kammerabschnitten (21, 22, 23) trennen, wobei,
die Nuten (18, 19, 24, 50) beinhalten:
eine erste Nut (18), die die Erste-Elektrode-Schicht (13), die photoelektrische Wandlungsschicht (14) und die Zweite-Elektrode-Schicht (15) durchdringt, und die die Erste-Elektrode-Schicht (13), die photoelektrische Wandlungsschicht (14) und die Zweite-Elektrode-Schicht (15) in einem ersten Kammerabschnitt (21a, 22a, 23a) und einen zweiten Kammerabschnitt (21b, 22b, 23b) trennt;
eine zweite Nut (19), in der eine Verdrahtungsschicht (30), die die Mehrzahl von Kammerabschnitten (21, 22, 23) elektrisch miteinander verbindet, gebildet ist, wobei die zweite Nut (19) parallel zu der ersten Nut (18) ist, und wobei die zweite Nut (19) die photoelektrische Wandlungsschicht (14) und die Zweite-Elektrode-Schicht (15) durchdringt und die photoelektrische Wandlungsschicht (14) und die Zweite-Elektrode-Schicht (15) in den zweiten Kammerabschnitt (21 b, 22b, 23b) und einen dritten Kammerabschnitt (21 c, 22c, 23c) trennt;
eine dritte Nut (24), die parallel zu der ersten Nut (18) ist und lateral zu der zweiten Nut (19) auf der der ersten Nut (18), die benachbart zu der zweiten Nut (19) ist, gegenüberliegenden Seite ist, wobei die dritte Nut (24) die photoelektrische Wandlungsschicht (14) und die Zweite-Elektrode-Schicht (15) durchdringt und die photoelektrische Wandlungsschicht (14) oder die Zweite-Elektrode-Schicht (15) in den dritten Kammerabschnitt (21 c, 22c, 23c) und einen vierten Kammerabschnitt (21d, 22d, 23d) trennt;
eine vierte Nut (50), die parallel zu der ersten Nut (18) ist, lateral zu der ersten Nut (18) auf der der zweiten Nut (19) gegenüberliegenden Seite, wobei die vierte Nut (50) die photoelektrische Wandlungsschicht (14) und die Zweite-Elektrode-Schicht (15) durchdringt und zumindest die photoelektrische Wandlungsschicht (14) und die Zweite-Elektrode-Schicht (15) in den vierten Kammerabschnitt (21d, 22d, 23d) und den ersten Kammerabschnitt (21a, 22a, 23a) zwischen der ersten Nut (18) und dem vierten Kammerabschnitt (21d, 22d, 23d), der ein effektiver Bereich (D1) zur Energieerzeugung wird, trennt, und wobei
eine Isolierschicht (31, 51), die zumindest die Erste-Elektrode-Schicht (13) von der photoelektrischen Wandlungsschicht (14) zwischen den Kammerabschnitten (21, 22, 23), die zueinander benachbart sind, isoliert, im Inneren der ersten Nut (18) gebildet ist;
eine Isolierschicht (31, 51), die zumindest die photoelektrische Wandlungsschicht (14) von der Zweite-Elektrode-Schicht (15) zwischen den Kammerabschnitten (21, 22, 23), die zueinander benachbart sind, isoliert, im Inneren der vierten Nut (50) gebildet ist; und
die Verdrahtungsschicht (30) von der Erste-Elektrode-Schicht (13), die an einer unteren Fläche der zweiten Nut (19) freiliegt, durch das Innere der zweiten Nut (19) und eine Oberfläche der Isolierschicht (31, 51), zu einer Oberfläche der Zweite-Elektrode-Schicht (15), die so angeordnet ist, dass sie lateral zu der vierten Nut (50) auf der der zweiten Nut (19) gegenüberliegenden Seite ist, verläuft, und die Verkabelungsschicht (30) die Mehrzahl von Kammerabschnitten (21, 22, 23) elektrisch miteinander verbindet.

## Revendications

1. Procédé de fabrication d'une photopile, le procédé comprenant un stade de traçage, dans lequel on forme des rainures (18, 19, 24, 50) séparant électriquement un convertisseur (12) photoélectrique en une pluralité de sections (21, 22, 23) de compartiment, après avoir formé le convertisseur (12) photoélectrique sur un substrat (11) en empilant une couche (13) de première électrode, une couche (14) photoélectrique de conversion et une couche (15) de deuxième électrode dans cet ordre, dans lequel
dans le stade de traçage,
on forme une première rainure (18), qui pénètre dans la couche (13) de première électrode, dans la couche (14) photoélectrique de conversion et dans la couche (15) de deuxième électrode et qui sépare la couche (13) de première électrode, la couche (14) photoélectrique de conversion et la couche (15) de deuxième électrode en une première section (21a, 22a, 23a) de compartiment et en une deuxième section (21 b, 22b, 23b) de compartiment,
on forme une deuxième rainure (19), parallèlement à la première rainure (18), la deuxième rainure (19) pénétrant dans la couche (14) photoélectrique de conversion et dans la couche (15) de deuxième électrode et la deuxième rainure (19) séparant la couche (14) photoélectrique de conversion et la couche (15) de deuxième électrode en la deuxième section (21 b, 22b, 23b) de compartiment et en une troisième section (21 c, 22c, 23c) de compartiment,
on forme une troisième rainure (24), parallèlement à la première rainure (18) et latéralement à la deuxième rainure (19) en opposition à la première rainure (18) au voisinage de la deuxième rainure (19), la troisième rainure (24) pénétrant dans la couche (14) photoélectrique de conversion et dans la couche (15) de deuxième électrode et la troisième rainure (24) séparant la couche (14) photoélectrique de conversion et la couche (15) de deuxième électrode en la troisième section (21c, 22c, 23c) de compartiment et en une quatrième section (21 d, 22d, 23d) de compartiment, et
on forme une quatrième rainure (50), parallèlement à la première rainure (18), latéralement à la première rainure (18) en opposition à la deuxième rainure (19), la quatrième rainure (50) pénétrant dans la couche (14) photoélectrique de conversion et dans la couche (15) de deuxième électrode et la quatrième rainure (50) séparant au moins la couche (14) photoélectrique de conversion et la couche (15) de deuxième électrode en la quatrième section (21d, 22d, 23d) de compartiment et en la première section (21a, 22a, 23a) de compartiment entre la première rainure (18) et la quatrième section (21d, 22d, 23d) de compartiment, qui
devient une région (D1) efficace pour produire du courant, dans lequel le procédé comprend :
un stade de formation d'une couche isolante, dans lequel une couche (31, 51) isolante est formée à l'intérieur de la première rainure (18) et de la quatrième rainure (50) après le stade de traçage ; et
un stade de formation d'une couche de câblage, dans lequel on forme une couche (30) de câblage reliant électriquement la pluralité de sections (21, 22, 23) de compartiment les unes aux autres, et dans lequel
dans le stade de formation d'une couche de câblage, la couche (30) de câblage passe de la couche (13) de première électrode, qui est mise à nu à une surface de fond de la deuxième rainure (19), en passant par l'intérieur de la deuxième rainure (19) et par une surface de la couche (31, 51) isolante, à une surface de la couche (15) de deuxième électrode, qui est disposée de manière à être latérale à la quatrième rainure (50) opposée à la deuxième rainure (19) et la couche (31) de câblage relie électriquement la pluralité de sections (21, 22, 23) de compartiment les unes aux autres.

2. Procédé de fabrication d'une photopile suivant la revendication 1, dans lequel
on utilise un laser infrarouge comme premier laser formant la première rainure (18) ;
on utilise un laser visible comme deuxième laser formant la deuxième rainure (19), comme troisième laser formant la troisième rainure (24) et comme quatrième laser formant la quatrième rainure (50) ; et
dans le stade de traçage, chacun des lasers balaye, de manière à ce qu'une position éclairée par un premier laser, une position éclairée par un deuxième laser, une position éclairée par un troisième laser et une position éclairée par un quatrième laser soient parallèles les unes aux autres, à des distances souhaitées entre elles, dans le convertisseur (12) photoélectrique et on forme ainsi chacune des rainures (18, 19, 24, 50).

3. Procédé de fabrication d'une photopile suivant la revendication 2, dans lequel
dans le stade de traçage, on fixe des positions relatives du premier laser, du deuxième laser, du troisième laser et du quatrième laser et chaque rainure (18, 19, 24, 50) est formée et balayée par chaque laser.

4. Procédé de fabrication d'une photopile suivant la revendication 3, dans lequel
dans le stade de traçage, on fixe des positions relatives du deuxième laser, du troisième laser et du quatrième laser, et
on forme la première rainure (18) et on la balaye par le premier laser après avoir formé et balayé par chaque laser en même temps la deuxième rainure (19), la troisième rainure (24) et la quatrième rainure (50).

5. Procédé de fabrication d'une photopile suivant la revendication 3, dans lequel
dans le stade de traçage, on fixe des positions relatives du premier laser, du deuxième laser, du troisième laser et du quatrième laser et chaque rainure (18, 19, 24, 50) est formée en même temps par le balayage de chaque laser simultanément.

6. Photopile comprenant :
un convertisseur (12) photoélectrique, dans lequel une couche (13) de première électrode, une couche (14) photoélectrique de conversion et une couche (15) de deuxième électrode sont empilées en couche dans cet ordre, le convertisseur (12) photoélectrique étant formé sur un substrat (11) ; et
des rainures (18, 19, 24, 50) séparant électriquement le convertisseur (12) photoélectrique en une pluralité de sections (21, 22, 23) de compartiment, dans laquelle
les rainures (18, 19, 24, 50) comprennent :
une première rainure (18) pénétrant dans la couche (13) de première électrode, dans la couche (14) photoélectrique de conversion et dans la couche (15) de deuxième électrode et séparant la couche (13) de première électrode, la couche (14) photoélectrique de conversion et la couche (15) de deuxième électrode en une première section (21a, 22a, 23a) de compartiment et en une deuxième section (21b, 22b, 23b) de compartiment ;
une deuxième rainure (19), dans laquelle une couche (30) de câblage reliant électriquement la pluralité des sections (21, 22, 23) de compartiment les unes aux autres est formée, la deuxième rainure (19) étant parallèle à la première rainure (18) et la deuxième rainure (19) pénétrant dans la couche (14) photoélectrique de conversion et dans la couche (15) de deuxième électrode et séparant la couche (14) photoélectrique de conversion et la couche (15) de deuxième électrode en la deuxième section (21 b, 22b, 23b) de compartiment et en une troisième section (21 c, 22c, 23c) de compartiment ;
une troisième rainure (24) étant parallèle à la première rainure (18) et latérale à la deuxième rainure (19) en opposition à la première rainure (18) au voisinage de la deuxième rainure (19), la troisième rainure (24) pénétrant dans la couche (14) photoélectrique de conversion et dans la couche (15) de deuxième électrode et séparant la couche (14) photoélectrique de conversion et la couche (15) de deuxième électrode en la troisième section (21c, 22c, 23c) de compartiment et en une quatrième section (21d, 22d, 23d) de compartiment ; et
une quatrième rainure (50) étant parallèle à la première rainure (18), latéralement à la première rainure (18) en opposition à la deuxième rainure (19), la quatrième rainure (50) pénétrant dans la couche (14) photoélectrique de conversion et dans la couche (15) de deuxième électrode et séparant au moins la couche (14) photoélectrique de conversion et la couche (15) de deuxième électrode en la quatrième section (21d, 22d, 23d) de compartiment et en la première section (21a, 22a, 23a) de compartiment entre la première rainure (18) et la quatrième section (21 d, 22d, 23d) de compartiment, qui devient une région (D1) efficace pour produire du courant, et dans lequel
une couche (31, 51) isolante, isolant au moins la couche (13) de première électrode de la couche (14) photoélectrique de conversion entre les sections (21, 22, 23) de compartiment voisines les unes des autres, est formée à l'intérieur de la première rainure (18) ;
une couche (31, 51) isolante, isolant au moins la couche (14) photoélectrique de la couche (15) de deuxième électrode entre les sections (21, 22, 23) de compartiment au voisinage les unes des autres, est formée à l'intérieur de la quatrième rainure (50) ; et
la couche (30) de câblage passe de la couche (13) de première électrode, qui est mise à nu en une surface de fond de la deuxième rainure (19), en passant par l'intérieur de la deuxième rainure (19) et par une surface de la couche (31, 51) isolante, à une surface de la couche (15) de deuxième électrode, qui est disposée de manière à être latérale à la quatrième rainure (50) opposée à la deuxième rainure (19), et la couche (30) de câblage reliée électriquement à la pluralité des sections (21, 22, 23) de compartiment les unes aux autres.
